(19) **Europäisches Patentamt European Patent Office Office européen des brevets**

(11) **EP 4 723 487 A1**

(12) **EUROPEAN PATENT APPLICATION**
published in accordance with Art. 153(4) EPC

(43) Date of publication:
08.04.2026 Bulletin 2026/15

(21) Application number: 24822359.6

(22) Date of filing: 08.04.2024

(51) International Patent Classification (IPC):
*H03M 13/11* (2006.01)

(52) Cooperative Patent Classification (CPC):
H03M 13/11; H04L 1/00

(86) International application number:
PCT/CN2024/086664

(87) International publication number:
WO 2024/255404 (19.12.2024 Gazette 2024/51)

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
GE KH MA MD TN

(30) Priority: 14.06.2023 CN 202310709637

(71) Applicant: ZTE Corporation
Shenzhen, Guangdong 518057 (CN)

(72) Inventors:
• LI, Liguang
Shenzhen, Guangdong 518057 (CN)

• XU, Jin
Shenzhen, Guangdong 518057 (CN)
• LIANG, Chulong
Shenzhen, Guangdong 518057 (CN)
• ZHAO, Wei
Shenzhen, Guangdong 518057 (CN)
• YU, Guanghui
Shenzhen, Guangdong 518057 (CN)
• FU, Qiang
Shenzhen, Guangdong 518057 (CN)
• KANG, Jian
Shenzhen, Guangdong 518057 (CN)

(74) Representative: Ziebig Hengelhaupt Intellectual
Property Attorneys
Patentanwaltskanzlei PartGmbB
Leipziger Straße 49
10117 Berlin (DE)

(54) **ENCODING METHOD AND APPARATUS, DECODING METHOD AND APPARATUS, AND STORAGE MEDIUM**

(57) The embodiments of the present application relate to the technical field of communications. Provided are an encoding method and apparatus, a decoding method and apparatus, and a storage medium, which can support higher data transmission rates. The encoding method comprises: acquiring a first bit sequence to be encoded; on the basis of a basic matrix of a spatial coupling low-density parity-check code (LDPC) and a lifting value, encoding the first bit sequence to obtain a second bit sequence, wherein the basic matrix comprises L sub-basic matrix groups which are the same and are arranged diagonally, each sub-basic matrix group comprises M first sub-basic matrixes, and L and M are both positive integers; and sending all or part of bits of the second bit sequence. The present application can be used in wire- less communication processes.

FIG. 4

```
Acquire a first bit sequence to be encoded                              S401

On the basis of a basic matrix of a spatial coupling LDPC and a lifting  S402
value, encode the first bit sequence to obtain a second bit sequence

Send all or part of bits of the second bit sequence                     S403
```

**Description**

The present disclosure claims a priority to Chinese Patent Application No. 202310709637.7, and filed on June 14, 2023, the entire content of which is incorporated into the present application by reference.

TECHNICAL FIELD

The present disclosure relates to the field of communication technologies, and in particular to an encoding method, a decoding method, an apparatus and a storage medium.

BACKGROUND

With the rapid development of technologies such as big data, cloud computing, and latency-sensitive networks, etc., the number of user equipment in wireless communication networks has experienced explosive growth. Wireless communication networks will carry diverse applications and massive amounts of data, which imposes high requirements on data transmission rate, throughput, reliability, latency, etc. Moreover, with the development of virtual reality/augmented reality, intelligent transportation, intelligent industrial control, intelligent logistics, and the like, there is an increasing demand for communications with ultra-high data rate, ultra-low latency, and ultra-high reliability. Compared with the existing 5G mobile communications, the demand for data transmission rate in the air interface standard protocol of future mobile communications will increase by one or two orders of magnitude. Therefore, there is an urgent need for an encoding and decoding method that may effectively improve the data transmission efficiency.

SUMMARY

Embodiments of the present disclosure provide an encoding method, a decoding method, an apparatus, and a storage medium that may support higher data transmission rates.
In an aspect, an encoding method is provided, and includes:

acquiring to-be-encoded first bit sequence;
encoding the first bit sequence based on a basic matrix of a spatially coupled low-density parity-check code (LDPC) and a lifting size, to obtain a second bit sequence, where the basic matrix includes L basic sub-matrix groups that are identical and arranged diagonally, and the basic sub-matrix group includes M first basic sub-matrices, where L and M are both positive integers; and
sending all or a part of bits of the second bit sequence.

In another aspect, a decoding method is provided, and includes:

receiving all or a part of bits of a second bit sequence; and
decoding the all or part of bits of the second bit sequence based on a basic matrix of a spatially coupled low-density parity-check code (LDPC) and a lifting size, to obtain a first bit sequence, where the basic matrix includes L basic sub-matrix groups that are identical and arranged diagonally, and the basic sub-matrix group includes M first basic sub-matrices, where L and M are both positive integers.

In yet another aspect, an encoding apparatus is provided, and includes: an acquiring module, an encoding module and a sending module;

the acquiring module is configured to, acquire a to-be-encoded first bit sequence;
the encoding module is configured to, encode the first bit sequence based on a basic matrix of a spatially coupled LDPC and a lifting size, to obtain a second bit sequence, where the basic matrix includes L basic sub-matrix groups that are identical and arranged diagonally, and the basic sub-matrix group includes M first basic sub-matrices, where L and M are both positive integers;
the sending module is configured to, send all or a part of bits of the second bit sequence.

In yet another aspect, a decoding apparatus is provided, and includes: a receiving module and a decoding module;

the receiving module is configured to, receive all or a part of bits of a second bit sequence;
the decoding module is configured to, decode the all or part of bits of the second bit sequence based on a basic matrix of a spatially coupled low-density parity-check code (LDPC) and a lifting size, to obtain a first bit sequence, where the basic matrix includes L basic sub-matrix groups that are identical and arranged diagonally, and the basic sub-matrix group includes M first basic sub-matrices, where L and M are both positive integers.

In yet another aspect, a communication apparatus is provided, and includes: a memory and a processor; the memory is coupled with the processor; the memory is configured to store a computer program; and the processor, when executing the computer program, implements the encoding method or the decoding method described in any one of the above embodiments.

In yet another aspect, a computer readable storage medium is provided and the computer readable storage medium has stored computer program instructions thereon, and the computer program instructions, when executed by a processor, implement the encoding method or the decoding method described in any one of the above embodiments.

In yet another aspect, a computer program product is provided, the computer program product includes computer program instructions, and the computer program instructions, when executed by a processor, implement the encoding method or the decoding method described in any one of the above embodiments.

The encoding method provided in the embodiments of the present disclosure may encode the first bit sequence (to-be-sent data) based on the basic matrix of spatially coupled LDPC and the lifting size. Due to the spatial coupling characteristics, SC-LDPC (Spatially Coupled LDPC) codes exhibit a "threshold saturation" phenomenon, which theoretically allows the spatially coupled LDPC codes to approach the Shannon capacity limit performance. Therefore, adopting spatially coupled LDPC for coding may support the need for higher data transmission rates.

BRIEF DESCRIPTION OF THE DRAWINGS

In order to illustrate technical solutions in the present disclosure more clearly, the drawings that some embodiments of the present disclosure need to use, will be briefly introduced below, and obviously, the drawings in the following description are merely drawings of some embodiments of the present disclosure, and other drawings may also be obtained according to these drawings for the ordinary skilled in the art.

FIG. 1 is a schematic diagram of an architecture of a communication system, provided by the embodiments of the present disclosure.

FIG. 2 is a flow diagram of data processing of a sending end and a receiving end provided by the embodiments of the present disclosure.

FIG. 3 is an original film diagram of a spatially coupled LDPC provided by the embodiments of the present disclosure.

FIG. 4 is a flow chart of an encoding method, provided by the embodiments of the present disclosure.

FIG. 5 is a flow chart of another encoding method, provided by the embodiments of the present disclosure.

FIG. 6 is a flow chart of yet another encoding method, provided by the embodiments of the present disclosure.

FIG. 7 is a schematic diagram of a Raptor-like structure, provided by the embodiments of the present disclosure.

FIG. 8 is a schematic diagram of a two-angle result, provided by the embodiments of the present disclosure.

FIG. 9 is a schematic diagram of an identity matrix structure, provided by the embodiments of the present disclosure.

FIG. 10 is a schematic diagram of a structure of a lower triangular structure, provided by the embodiments of the present disclosure.

FIG. 11 is a schematic diagram of a quasi-lower triangular structure, provided by the embodiments of the present disclosure.

FIG. 12 is a schematic diagram of a structure of a parity column matrix, provided by the embodiments of the present disclosure.

FIG. 13 is a schematic diagram of a structure of a first basic sub-matrix, provided by the embodiments of the present disclosure.

FIG. 14 is a schematic diagram of a structure of a second basic sub-matrix, provided by the embodiments of the present disclosure.

FIG. 15 is a schematic diagram of a structure of another first basic sub-matrix, provided by the embodiments of the present disclosure.

FIG. 16 is a schematic diagram of a structure of yet another first basic sub-matrix, provided by the embodiments of the present disclosure.

FIG. 17 is a schematic diagram of a structure of yet another first basic sub-matrix, provided by the embodiments of the present disclosure.

FIG. 18 is a schematic diagram of a structure of yet another first basic sub-matrix, provided by the embodiments of the present disclosure.

FIG. 19 is a schematic diagram of a structure of yet another first basic sub-matrix, provided by the embodiments of the present disclosure.

FIG. 20 is a schematic diagram of a structure of a parity column matrix, provided by the embodiments of the present disclosure.

FIG. 21 is a flow chart of a decoding method, provided by the embodiments of the present disclosure.

FIG. 22 is a schematic diagram of components of an encoding apparatus, provided by the embodiments of the present disclosure.

FIG. 23 is a schematic diagram of components of a decoding apparatus, provided by the embodiments of the present disclosure.

FIG. 24 is a schematic diagram of components of a communication apparatus, provided by the embodiments of the present disclosure.

FIG. 25 is a comparison schematic diagram of data simulation performance, provided by the embodiments of the present disclosure.


## DETAILED DESCRIPTION

The following will describe the technical solutions in the present disclosure clearly and completely, in conjunction with the drawings in the present disclosure, and obviously, the described embodiments are only a part of the embodiments of the present disclosure, not all of the embodiments. Based on the embodiments of the present disclosure, all other embodiments obtained by those ordinary skilled in the art without making inventive efforts fall within the scope of protection of the present disclosure.

It should be noted that in the present disclosure, terms such as "exemplary/exemplarily" or "for example" are used to represent examples, illustrations, or descriptions. Any embodiment or design solution described with "exemplary/exemplarily" or "for example" should not be interpreted as being more preferred or advantageous than other embodiments or design solutions. Rather, the usage of the words, such as "exemplary / exemplarily" or "for example", is intended to present relevant concepts in a specific manner.

Hereinafter, the terms such as "first", "second", etc., are used only for descriptive purposes and cannot be construed as indicating or implying relative importance or implicitly indicating the number of the indicated technical features. Thus, features defined with "first" or "second", etc., may explicitly or implicitly include one or more of the features.

In the description of the present disclosure, unless otherwise specified, the symbol "/" means "or", and for example, A/B may represent A or B. Herein, "and/or" is only used to describe an associated relationship between associated objects, representing that there may be three relationships, and for example, A and/or B may represents three cases: only A, A and B, and only B. Additionally, "at least one" means one or more, and "multiple/plurality of" means two or more.

The technical solutions provided in the embodiments of the present disclosure may be applied to various mobile communication networks, for example, new radio (New Radio, NR) mobile communication networks using the fifth generation mobile communication technology (5th generation mobile networks, 5G), future mobile communication networks or multiple communication fusion systems, etc., which are not limited to the embodiments of the present disclosure.

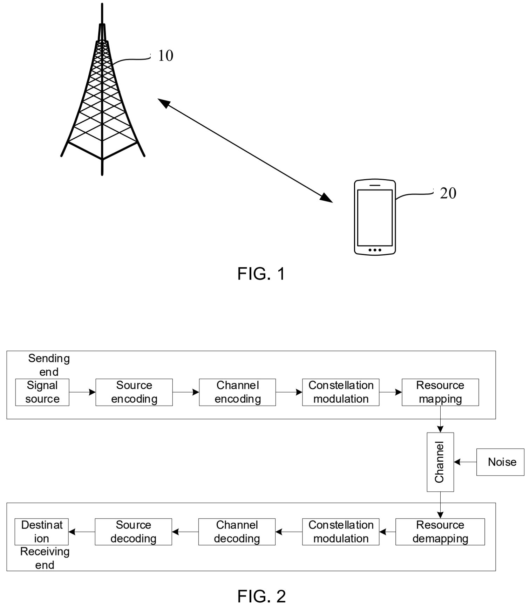

FIG. 1 shows a schematic diagram of an architecture of a communication system, provided by the embodiments of the present disclosure. As shown in FIG. 1, the communication system includes a base station 10 and a terminal 20.

In some embodiments, the base station 10 is used to provide radio access services to a plurality of terminals. Specifically, a base station provides a service coverage area (also referred to as a cell). A terminal entering the area may communicate with the base station by a wireless signal, to receive a radio access service provided by the base station.

In some embodiments, a base station 10 may be a base station or an evolutional base station (evolutional node B, eNB or eNodeB) in long term evolution (LTE), long term evolution advanced (LTEA), a base station device in a 5G network, or a base station in a future communication system, etc., the base station may include various macro base stations, micro base stations, home base stations, wireless remote, reconfigurable intelligent surface (RIS), routers, wireless fidelity (WIFI) devices, or various network side devices etc.

In some embodiments, the terminal 20 may be a device with a wireless transceiving function, may be deployed on land (including indoors or outdoors, handheld, worn or in-vehicle); may also be deployed on the water (e.g., on a ship, etc.); may also be deployed in the air (e.g., on an airplane, a balloon and a satellite, etc.). The terminal may be a mobile phone, a pad, a computer with a wireless transceiver function, a virtual reality (Virtual Reality, VR) terminal, an augmented reality (Augmented Reality, AR) terminal, a wireless terminal in industrial control, a wireless terminal in self driving, a wireless terminal in remote medical, a wireless terminal in a smart grid, a wireless terminal in transportation safety, a wireless terminal in a smart city, a wireless terminal in a smart home, etc. The embodiments of the present disclosure do not limit the application scenarios. The terminal sometimes may also be referred to as a user, a user equipment (User Equipment, UE), an access terminal, a UE unit, a UE station, a mobile station, a mobile platform, a remote station, a remote terminal, a mobile device, a UE terminal, a wireless communication device, a UE agent, or a UE apparatus, etc., which is not limited to the embodiments of the present disclosure.

The embodiments of the present disclosure may be applied to downlink data transmission, may also be applied to uplink data transmission, and may further be applied to device-to-device data transmission. For downlink data transmission, a sending end is a base station, and a corresponding receiving end is a terminal. For uplink data transmission, a sending end is a terminal, and a corresponding receiving end is a base station. In device-to-device data transmission, a sending end is a terminal, and a corresponding receiving end is also a terminal. Both the sending end and the receiving end in the present disclosure may include an encoding apparatus and/or a decoding apparatus, so that information to be sent may be modulated and encoded, and received encoded information may be demodulated and decoded, thereby achieving information transmission between the sending end device and the receiving end device. The embodiments of the present disclosure do not limit thereto.

It should be noted that, FIG. 1 is only an exemplary framework diagram, and a number of devices and names of the various devices included in FIG. 1 are not limited, and in addition to the devices shown in FIG. 1, the communication system may also include other devices, such as a core network device.

The embodiments of the present disclosure do not limit application scenarios. The system architectures and the service scenarios described in the embodiments of the present disclosure are provided for more clearly explaining the technical solutions of the embodiments of the present disclosure, and do not constitute a limitation on the technical solutions provided in the embodiments of the present disclosure, and the ordinary skilled in the art may know that with the evolution of the network architectures and the emergence of new service scenarios, the technical solutions provided in the embodiments of the present disclosure are also applicable to similar technical problems.

FIG. 2 is a flow diagram of data processing of a sending end and a receiving end. As shown in FIG. 2, the sending end sends a signal obtained by performing source encoding, channel encoding, constellation modulation, and resource mapping on an information source (i.e., to-be-transmitted data) to the receiving end. The receiving end, after receiving the signal, performs resource demapping, constellation demodulation, channel decoding, and source decoding, to obtain a destination (i.e., a restored signal source).

In a data transmission process, data errors may occur due to the influence of factors such as multipath, movement, noise, and interference, etc. Therefore, the sending end adds some pieces of redundant information to the to-be-transmitted data through channel encoding, and the receiving end may restore the original to-be-transmitted data according to these pieces of redundant information, that is, the distortion caused by the data in the transmission process is eliminated. Currently, commonly used channel coding methods may include LDPC, polar coding, turbo coding, and convolutional coding, etc.

The LDPC is defined by a sparse (or low-density) parity basic matrix, and its decoding performance may be improved through iterative decoding, such as adopting belief propagation decoding.

The parity matrix H of the LDPC code is a matrix of $m_b \times Z$ rows and $n_b \times z$ columns, which is composed of $m_b \times n_b$ sub-matrices, each of which is a different power of a $Z \times z$ standard permutation matrix (corresponding to the cyclic shift matrix of the identity matrix) or a $Z \times z$ all-zero square matrix. The parity matrix H has the following form:

$$H = \begin{bmatrix} P^{h_{00}^b} & P^{h_{01}^b} & P^{h_{02}^b} & \dots & P^{h_{0n_b}^b} \\ P^{h_{10}^b} & P^{h_{11}^b} & P^{h_{12}^b} & \dots & P^{h_{1n_b}^b} \\ \vdots & \vdots & \vdots & \ddots & \vdots \\ P^{h_{m_b0}^b} & P^{h_{m_b2}^b} & P^{h_{m_b2}^b} & \dots & P^{h_{m_bn_b}^b} \end{bmatrix} = P^{H_b}$$

If $h_{ij}^b = -1$, then $P^{h_{ij}^b} = 0$, that is, a $Z \times Z$ all-zero square matrix; if $h_{ij}^b$ is an integer greater than equal to 0, the corresponding sub-matrix is the $h_{ij}^b$-th power of the standard permutation matrix P (i.e., the cyclic shift of the identity matrix), the $Z \times Z$ standard permutation matrix P is as follows (the standard permutation matrix may be formed by cyclically shifting the identity matrix to the right by 1 bit):

$$P = \begin{bmatrix} 0 & 1 & 0 & \dots & 0 \\ 0 & 0 & 1 & \dots & 0 \\ \vdots & \vdots & \vdots & \ddots & \vdots \\ 0 & 0 & 0 & \dots & 1 \\ 1 & 0 & 0 & \dots & 0 \end{bmatrix}$$

Therefore, $h_{ij}^b$ may uniquely identify each sub-matrix. If a certain sub-matrix is an all-zero square matrix, the corresponding $h_{ij}^b$ is represented by -1 (it may also be represented by a null value or other description manners); if a certain sub-matrix is obtained by the cyclic shift s of the identity matrix, then $h_{ij}^b$ is equal to s. All $h_{ij}^b$ may form a basic matrix. Therefore, the base matrix includes two types of elements: elements indicating all-zero square matrices and elements indicating cyclic shifts of the identity matrix.

Z is a dimension of the standard permutation matrix (sub-matrix), and Z may be referred to as the lifting size. By replacing the elements indicating cyclic shifts of the identity matrix in the basic matrix with "1" and all elements indicating all-zero square matrices with "0", the basic matrix (BG) of the LDPC code may be obtained. Therefore, the basic matrix of the LDPC code only includes two types of elements: "0" and "1", where "0" is used to indicate that the index position is an element of an all-zero square matrix, and "1" is used to indicate that the index position is an element of a cyclic shift of the identity matrix. For the convenience of description, only the elements indicating cyclic shifts of the identity matrix in the basic matrix and the row and column index positions of these elements may be described, and the remaining row and column index positions are defaulted to elements indicating all-zero square matrices. Additionally, the elements indicating the cyclic shifts of the identity matrix may be represented by the cyclic shift values thereof, while elements indicating the all-zero matrix may be described by -1 or null.

For example, the basic matrix (2 rows and 4 columns) of the 1 LDPC code is as follows:

$$\begin{bmatrix} 0 & 3 & 0 & -1 \\ 2 & 3 & 2 & 3 \end{bmatrix}$$

In a case where the lifting size is equal to 4, the corresponding parity matrix H is as follows.

$$\mathbf{H} = \left[\begin{array}{cccc|cccc|cccc|cccc} 1&0&0&0 & 0&0&0&1 & 1&0&0&0 & 0&0&0&0 \\ 0&1&0&0 & 1&0&0&0 & 0&1&0&0 & 0&0&0&0 \\ 0&0&1&0 & 0&1&0&0 & 0&0&1&0 & 0&0&0&0 \\ 0&0&0&1 & 0&0&1&0 & 0&0&0&1 & 0&0&0&0 \\ \hline 0&0&1&0 & 0&0&0&1 & 0&0&1&0 & 0&0&0&1 \\ 0&0&0&1 & 1&0&0&0 & 0&0&0&1 & 1&0&0&0 \\ 1&0&0&0 & 0&1&0&0 & 1&0&0&0 & 0&1&0&0 \\ 0&1&0&0 & 0&0&1&0 & 0&1&0&0 & 0&0&1&0 \end{array}\right]$$

The corresponding basic matrix is as follows:

$$BG = \begin{bmatrix} 1 & 1 & 1 & 0 \\ 1 & 1 & 1 & 1 \end{bmatrix}$$

Spatially coupled LDPC is a channel encoding derived from LDPC convolutional codes. Spatially coupled LDPC combines the respective advantages of LDPC codes and convolutional codes, not only having excellent decoding and error-correcting performance but also satisfying the requirements of high-speed encoding and decoding of block LDPC codes. The spatially coupled feature causes the spatially coupled LDPC codes to exhibit a "threshold saturation" phenomenon, which enables the SC-LDPC codes to theoretically approach the Shannon capacity limit performance.

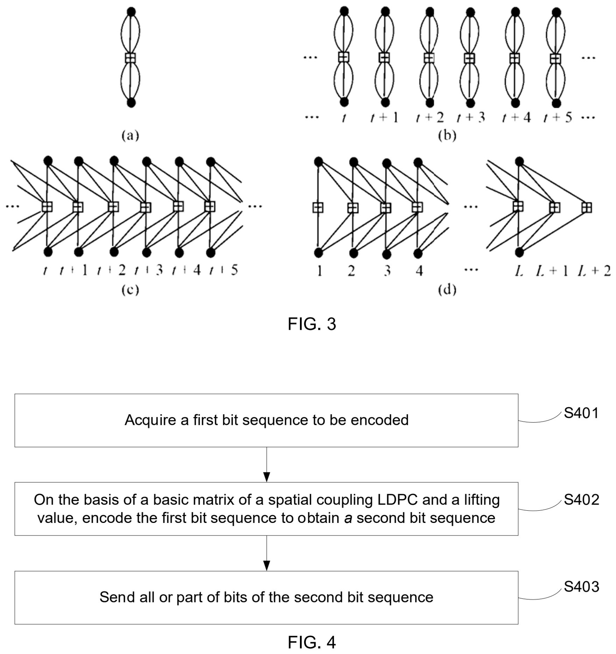

The coupling principle of spatially coupled LDPC codes is described below using protograph coupling, and FIG. 3 is a schematic diagram of a process for obtaining a protograph diagram of the spatially coupled LDPC from a protograph, provided by the embodiments of the present disclosure. Herein, black dots represent variable nodes, plus squares represent parity nodes, and the solid lines connecting variable nodes and parity nodes are referred to edges. (a) in FIG. 3 is a protograph of the LDPC code; (b) in FIG. 3 is that the protograph of the LDPC code is copied a plurality of times for coupling, where serial numbers such as t, t+1, t+2, etc., represent the indices of the copied protographs, and the number of copies may be referred as the coupling chain length; (c) in FIG. 3 is that some edges in each protograph are decoupled and reconnected to the subsequent LDPC protographs, and a maximum distance of the connection is limited by the constraint length, which may be referred to as a coupling width (Coupling Width); (d) in FIG. 3 is the protograph of the spatially coupled LDPC after protograph coupling.

As shown in FIG. 4, the embodiments of the present disclosure provide an encoding method, applied to an encoding apparatus and the method at least includes S401 to S403.

In S401, a to-be-encoded first bit sequence is acquired.

In S402, the first bit sequence is encoded based on a basic matrix and as lifting size of a spatially coupled LDPC, to obtain a second bit sequence.

In S403, all or a part of bits of the second bit sequence are sent.

Herein, the basic matrix of the spatially coupled LDPC includes L basic sub-matrix groups that are identical and arranged diagonally, and the basic sub-matrix group includes M first basic sub-matrices, where L and M are both positive integers.

Exemplarily, the basic matrix of the spatially coupled LDPC may be represented as follows:

$$
Hb_{SC} = \begin{bmatrix}
Hb_0^{(0)} & & & & \\
Hb_1^{(0)} & Hb_0^{(1)} & & & \\
\vdots & Hb_1^{(1)} & \ddots & & \\
Hb_{M-1}^{(0)} & \vdots & \ddots & Hb_0^{(L-1)} & \\
& Hb_{M-1}^{(1)} & \ddots & Hb_1^{(L-1)} & \\
& & \ddots & Hb_2^{(L-1)} & \\
& & \ddots & \vdots & \\
& & & Hb_{M-1}^{(L-1)} &
\end{bmatrix}
$$

Herein, L is a length of a coupling chain and M is a coupling width (or a coupling depth).

It should be understood that, the above $Hb_0^{(0)}$, $Hb_1^{(0)}$, ..., $Hb_{M-1}^{(0)}$ form a first basic sub-matrix group; $Hb_0^{(1)}$, $Hb_1^{(1)}$, ..., $Hb_{M-1}^{(1)}$ form a second basic sub-matrix group; and so on, $Hb_0^{(L-1)}$, $Hb_1^{(L-1)}$, ..., $Hb_{M-1}^{(L-1)}$ form a L-th basic sub-matrix group. Elements in the basic matrix of the spatially coupled LDPC may be either a first element or a second element, the first element is used to indicate an all-zero square matrix, and the second element may be represented by a cyclic shift value of an identity matrix.

In some embodiments, the first first basic sub-matrix group, the second basic sub-matrix group, ..., the L-th basic sub-matrix group are all composed of M first basic sub-matrices, that is, the i-th basic sub-matrix group all include identical M first basic sub-matrices, where i is any positive integer less than or equal to L. That is, the first first basic sub-matrix group, the second basic sub-matrix group, ..., the L-th basic sub-matrix group are all composed of M first basic sub-matrices $Hb_0$, $Hb_1$, ..., $Hb_{M-1}$, where $Hb_0$ is referred to as a first first basic sub-matrix, $Hb_1$ is referred to as a second first basic sub-matrix, ..., and $Hb_{M-1}$ is referred to as an M-th first basic sub-matrix.

In some embodiments, a number of rows of the M first basic sub-matrices is $m_b$, a number of columns of the M first basic sub-matrices is $n_b$, $n_b$ is greater than $m_b$, and both $m_b$ and $n_b$ are positive integers.

The basic matrix of the spatially coupled LDPC includes L basic sub-matrix groups that are identical and arranged diagonally, the basic sub-matrix group includes M first basic sub-matrices, which may be understood as follows: the sub-matrix formed by the $((i-1)*n_b+1)$-th column to the $(i*n_b)$-th column and the $((j-1)*m_b+(i-1)*m_b+1)$-th row to the $((j-1)*m_b+i*m_b)$-th row in the basic matrix of the spatially coupled LDPC is a j-th first basic sub-matrix, where i is any positive integer less than or equal to L and i is any positive integer less than or equal to M.

In some embodiments, the coupling width M of the spatially coupled LDPC may be equal to at least one of: 2, 3, 4, 5, 6, or 7.

In some embodiments, elements in the first basic sub-matrix may be either the first element or the second element. Herein, the first element is used to indicate an all-zero square matrix, and the first element may be represented by -1 or a null value. The second element is used to indicate a cyclic shift of the identity matrix, and the second element may be represented by a cyclic shift value of the identity matrix.

In some embodiments, the first basic sub-matrix includes a system column matrix and a parity column matrix, the system column matrix is formed by elements in first $k_b$ columns of the first basic sub-matrix, the parity column matrix is formed by elements in last $m_b$ columns of the first basic sub-matrix, and a sum of $k_b$ and $m_b$ is equal to a number $n_b$ of columns of the first basic sub-matrix, and $k_b$ and $m_b$ both are positive integers. Exemplarily, the first basic sub-matrix may a structure as follows: [Hb$^s$, Hb$^p$]. Herein, Hb$^s$ is the above system column matrix, and Hb$^p$ is the above parity column matrix. The system column matrix Hb$^s$ and the parity column matrix Hb$^p$ have a same number of rows, both being $m_b$.

In some embodiments, the parity column matrix of at least one first basic sub-matrix of the M first basic sub-matrices adopts any one of following structures:

1. a Raptor-like structure;

2. an identity matrix structure;

3. a lower triangular structure;

4. a quasi-lower triangular structure; the quasi-lower triangular structure representing that a lower right part of the matrix is a lower triangular structure;

5. a first preset structure, column weights of first a columns of the parity column matrix adopting the first preset structure are greater than 0, and column weights of remaining columns are equal to 0 other than the first a columns, where a is a positive integer; the column weight is a number of second elements in a column of elements of, and the second element is used to indicate cyclic shift of the identity matrix;

6. a second preset structure, where all elements of the parity column matrix adopting the second preset structure are first elements, and the first element is used to indicate an all-zero square matrix.

In some embodiments, the parity column matrix of a first first basic sub-matrix among the M first basic sub-matrices adopts a Raptor-like structure or an identity matrix structure. Thus, the matrix inversion operation of the first first basic sub-matrix may be simplified during the encoding process, thereby reducing the encoding complexity.

In some embodiments, a structure of the parity column matrix of the first first basic sub-matrix among the M first basic sub-matrices may be determined by at least one of following parameters: a length of the first bit sequence, a number of first bit subsequences included in the first bit sequence, and a length of the first bit subsequence.

Exemplarily, the following three implementations may be used to determine whether the parity column matrix adopts a Raptor-like structure or an identity matrix structure:

Implementation 1, in a case where a length of the first bit sequence (also referred to as a size of a transport block) is greater than a first threshold, the parity column matrix of the first first basic sub-matrix adopts a Raptor-like structure, where the first threshold is a positive integer, in a case where the length of the first bit sequence is less than or equal to the first threshold, the parity column matrix of the first first basic sub-matrix does not adopt a Raptor-like structure; alternatively, in a case where the length of the first bit sequence is less than or equal to a second threshold, the parity column matrix of the first first basic sub-matrix adopts an identity matrix structure, where the second threshold is a positive integer and in a case where the length of the first bit sequence is greater than the second threshold, the parity column matrix of the first first basic sub-matrix does not adopt an identity matrix structure. In an example, the first threshold is greater than or equal to the second threshold. As an example, the first threshold is an integer greater than 512. As another example, the second threshold is an integer greater than 256. As another specific example, the first threshold is equal to the second threshold, the first threshold is an integer equal to 4096 and less than 40960, or the first threshold is an integer greater than or equal to 4096 and less than or equal to 16384. For example, the first threshold may be equal to 4096, 6144, 8192, 8448, 16384, 20000, or 40960. In an example, the first threshold is equal to the second threshold, in a case where the length of the first bit sequence is greater than the first threshold, the parity column matrix of the first first basic sub-matrix adopts a Raptor-like structure; otherwise, an identity matrix structure is adopted.

Implementation 2, the first bit sequence may include L first bit subsequences (or referred to as information bit subsequences), in a case where the length of the first bit subsequence is greater than a third threshold, the parity column matrix of the first first basic sub-matrix adopts a Raptor-like structure, the third threshold is a positive integer, in a case where the length of the first bit subsequence is less than or equal to the third threshold, the parity column matrix of the first first basic sub-matrix does not adopt the Raptor-like structure; alternatively, in a case where the length of the first bit subsequence is less than or equal to a fourth threshold, the parity column matrix of the first first basic sub-matrix adopts an identity matrix structure, the fourth threshold is a positive integer and in a case where the length of the first bit subsequence is greater than the fourth threshold, the parity column matrix of the first first basic sub-matrix does not adopt the identity matrix structure. In an example, the third threshold is greater than or equal to the fourth threshold, and L is a positive integer. As an example, the third threshold is an integer greater than or equal to 256 and less than 4096, or the third threshold is an integer greater than or equal to 256 and less than or equal to 1024. As an example, the fourth threshold is an integer greater than or equal to 256 and less than 4096, or the fourth threshold is an integer greater than or equal to 512 and less than or equal to 2048. For example, the third threshold or fourth threshold is equal to 256, 512, 768, 1024, 1536, or 2048. In an example, the third threshold may be equal to the fourth threshold, in a case where the length of the first bit sequence is greater than the third threshold, the parity column matrix of the first first basic sub-matrix adopts a Raptor-like structure; otherwise, an identity matrix structure is adopted.

Implementation 3, the first bit sequence may include L first bit subsequences (or referred to as information bit subsequences), in a case where a number L of first bit subsequences is greater than a fifth threshold, the parity column matrix of the first first basic sub-matrix adopts a Raptor-like structure, where the fifth threshold is a positive integer, in a case where the number L of first bit subsequences is less than or equal to the fifth threshold, the parity column matrix of the first first basic sub-matrix does not adopt the Raptor-like structure; alternatively, in a case where the number L of first bit subsequences is less than or equal to a sixth threshold, the parity column matrix of the first first basic sub-matrix adopts an identity matrix structure, where the sixth threshold is a positive integer and L is a positive integer and in a case where the number L of first bit subsequences is greater than the sixth threshold, the parity column matrix of the first first basic sub-matrix does not adopt the identity matrix structure. In an example, the fifth threshold is greater than or equal to the sixth threshold. As an example, the fifth threshold is an integer greater than or equal to 8 and less than 64, or the fifth threshold is an integer greater than or equal to 16 and less than or equal to 48. As an example, the sixth threshold is an integer greater than or equal to 8 and less than 64, or the sixth threshold is an integer greater than or equal to 16 and less than or equal to 48. For example, the fifth threshold or sixth threshold is equal to 8, 12, 16, 20, 24, 32, 36, 48, 56, or 64. In an example, the fifth threshold may be equal to the sixth threshold, in a case where the length of the first bit sequence is greater than the fifth threshold, the parity column matrix of the first first basic sub-matrix adopts a Raptor-like structure; otherwise, an identity matrix structure is adopted.

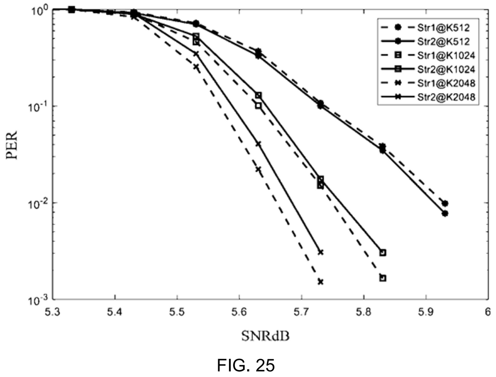

It should be understood that, through experimental simulations, in a case where the length of the first bit sequence or the length of the first bit subsequence is relatively long, the parity column matrix of the first first basic sub-matrix adopting the Raptor-like structure has better coding performance than adopting the identity matrix structure. In a case where the length of the first bit sequence or the length of the first bit subsequence is relatively short, the parity column matrix of the first first basic sub-matrix adopting the identity matrix structure has better coding performance than adopting the Raptor-like structure. As shown in FIG. 25, a horizontal ordinate represents a ratio (generally referred to as signal-to-noise ratio) of signal power to noise power under a Gaussian channel, with the unit of decibels; a vertical ordinate is a packet error rate, with a value less than or equal to 1 and greater than or equal to 0, at the same signal-to-noise ratio, the lower the packet error rate, the better the performance, or in other words, the closer the curve is to the left, the better the performance. In FIG. 25, the label "Str1" corresponds to the parity column matrix of the first first basic sub-matrix adopting the Raptor-like structure (corresponding to a dashed curve), and label "Str2" corresponds to the parity column matrix of the first first basic sub-matrix adopting the identity matrix structure (corresponding to a solid curve) and the corresponding coupling chain length L is equal to 80, and the coupling width is equal to 2. Performance comparisons are given for the lengths of the first bit subsequence being 512, 1024, and 2048, respectively. It may be seen that, when the length of the first bit subsequence is 512, the performance of the label "Str2" is slightly better than the performance of the label "Str1", while when the length of the first bit subsequence is 1024 and 2048, the performance of the label "Str1" is better than the performance of the label "Str2".

In some embodiments, structures of the parity column matrices of any two first basic sub-matrices among the M first basic sub-matrices are different. The parity column matrix of the first first basic sub-matrix and the parity column matrix of the second first basic sub-matrix will be introduced exemplarily below.

Example 1, the parity column matrix of the first first basic sub-matrix among the M first basic sub-matrices adopts the Raptor-like structure, and the parity column matrix of the second first basic sub-matrix among the M first basic sub-matrices adopts the identity matrix structure.

Example 2, the parity column matrix of the first first basic sub-matrix among the M first basic sub-matrices adopts the identity matrix structure, and the parity column matrix of the second first basic sub-matrix among the M first basic sub-matrices adopts the Raptor-like structure.

Example 3, the parity column matrix of the first first basic sub-matrix adopts the Raptor-like structure, and the parity column matrix of the second first basic sub-matrix adopts a first preset structure. As an example, a value of a is less than or equal to a number of rows of a core matrix of the first first basic sub-matrix. As an example, the number of rows of the core matrix of the first first basic sub-matrix is equal to 3, 4, 5, 6, or 8. Herein, the core matrix of the first basic sub-matrix is a matrix formed by the top-left $m_{b0}$ rows and kb+$m_{b0}$ columns of the first basic sub-matrix, where $m_{b0}$ may be equal to 3, 4, 5, 6, or 8.

Example 4, the parity column matrix of the first first basic sub-matrix among the M first basic sub-matrices adopts the identity matrix structure, and the parity column matrix of the second first basic sub-matrix among the M first basic sub-matrices adopts the first preset structure. As an example, a is equal to 2, 3, 4, 5, 6, or 8.

In some embodiments, there are b columns with the column weights equal to 0 and remaining columns with the column weights greater than 0 other than the b columns in the system column matrix of at least one first basic sub-matrix among the M first basic sub-matrices, the column weight is a number of second elements in a column of elements, and b is a positive integer. As an example, b columns with column weights equal to 0 are first b columns of the system column matrix. As an example, the value of b is equal to a puncturing quantity in the system column. In a specific example, b may be equal to 1 or 2.

In some embodiments, the lifting value is equal to a positive integer power of 2. For example, the lifting size may be equal to 8, 16, 32, 64, 128, 256, or 512.

In some embodiments, the basic matrix of the spatially coupled LDPC may further include N second basic sub-matrices other than the L basic sub-matrix groups, where N is a positive integer. It should be understood that, N second basic sub-matrices may enhance the error correction performance of the spatially coupled LDPC.

In some embodiments, a number of columns of the N second basic sub-matrices is $m_b$, and a number of rows of the N second basic sub-matrices is $m_b$, and $m_b$ is a positive integer. That is, the second basic sub-matrix is a square matrix.

In some embodiments, the N second basic sub-matrices are arranged on a diagonal of a lower right sub-matrix of the basic matrix of the spatially coupled LDPC. As an example, the lower right sub-matrix is formed by the N*$m_b$ columns and N*$m_b$ rows in the lower right part of the basic matrix of the spatially coupled LDPC.

The N second basic sub-matrices are arranged on the diagonal of the lower right sub-matrix of the basic matrix of the spatially coupled LDPC, which may be understood as follows: the sub-matrix formed by the L*$n_b$+ (s-1)*$m_b$+1 columns to the L*$n_b$+s*$m_b$ columns and the L*$m_b$+ (s-1)*$m_b$+1 rows to the L*$m_b$+ s*$m_b$ rows in the basic matrix of the spatially coupled LDPC is the s-th second basic sub-matrix, where s is any positive integer less than or equal to N.

In some embodiments, the second basic sub-matrix adopts any one of following structures:

    1. a Raptor-like structure;
    2. an identity matrix structure;
    3. a lower triangular structure;
    4. a quasi-lower triangular structure.

It should be understood that, adopting the above structure for the second basic sub-matrix may simplify the inversion operation of the second basic sub-matrix during the encoding process, which conductive to reducing the encoding complexity.

In some embodiments, a number N of the second basic sub-matrix is less than a number M of the first basic sub-matrix. For example, the number of second basic sub-matrices is equal to M-1, where M is an integer greater than 1, and M is a coupling width of the spatially coupled LDPC.

Exemplarily, taking an example of N=M-1, the basic matrix of spatially coupled LDPC may be represented as:

$$
Hb_{SC} = \begin{bmatrix}
Hb_0^{(0)} & & & & & & \\
Hb_1^{(0)} & Hb_0^{(1)} & & & & & \\
\vdots & Hb_1^{(1)} & \ddots & & & & \\
Hb_{M-1}^{(0)} & \vdots & \ddots & Hb_0^{(L-1)} & & & \\
& Hb_{M-1}^{(1)} & \ddots & Hb_1^{(L-1)} & Tb_0 & & \\
& & \ddots & Hb_2^{(L-1)} & & Tb_1 & \\
& & \ddots & \vdots & & & Tb_1 \\
& & & Hb_{M-1}^{(L-1)} & & & & Tb_{M-2}
\end{bmatrix}
$$

Herein, Hb represents the first basic sub-matrix and Tb represents the second basic sub-matrix. L is the length of the coupling chain during spatial coupling, and M is the coupling width (or coupling depth). For the specific spatial coupling process, reference may be made to the relevant technical documents on protograph coupling, which will not be elaborated herein. As may be seen, the basic matrix $Hb_{SC}$ includes a plurality of sub-matrices that are not all equal to 0 (such as $Hb_i^{(t)}$ and $Tb_j$). Other than these $Hb_i^{(t)}$ and $Tb_j$, remaining elements are equal to 0, that is, they are all elements indicating an all-zero square matrix, where i = 0, 1, ..., M-1, t = 0, 1, ..., L-1, and j = 0, 1, ..., M-2. Elements in the basic matrix of the spatially coupled LDPC may be either the first element or the second element, the first element is used to indicate the all-zero square matrix, and the second element may be represented by a cyclic shift value of an identity matrix.

In some embodiments, based on the basic matrix of spatially coupled LDPC and the lifting size, that is, replacing the first element in the basic matrix with an all-zero square matrix of size Z rows by Z columns, and replacing the second element with a matrix obtained by cyclically shifting an identity matrix of size Z rows by Z columns, where the cyclic shift size is the value of the second element and the parity-check matrix of the spatially coupled LDPC code may be obtained. Exemplarily, the coupling parity matrix of the spatially coupled LDPC may be represented by a formula as follows:

$$H_{SC} = \begin{bmatrix} H_0^{(0)} & & & & & & & \\ H_1^{(0)} & H_0^{(1)} & & & & & & \\ \vdots & H_1^{(1)} & \ddots & & & & & \\ H_{M-1}^{(0)} & \vdots & \ddots & H_0^{(L-1)} & & & & \\ & H_{M-1}^{(1)} & \ddots & H_1^{(L-1)} & T_0 & & & \\ & & \ddots & H_2^{(L-1)} & & T_1 & & \\ & & \ddots & \vdots & & & \ddots & \\ & & & H_{M-1}^{(L-1)} & & & & T_{M-2} \end{bmatrix}$$

Herein, the elements in the coupling parity matrix $H_{SC}$ at least include 0 and 1, the coupling parity matrix $H_{SC}$ includes a plurality of sub-matrices that are not all equal to 0 (such as a first parity-check sub-matrix $H_i^{(t)}$ and a second parity-check sub-matrix $T_j$), other than these $H_i^{(t)}$ and $T_j$, remaining elements are equal to 0, where i = 0, 1, ..., M-1, t = 0, 1, ..., L-1, and j = 0, 1, ..., M-2. Herein, the size of $H_i^{(t)}$ is m rows by n columns, and the size of $T_j$ is m rows by m columns, where both m and n are positive integers. Herein, n is equal to a product of $n_b$ and Z, and m is equal to a product of $m_b$ and Z, where Z is the lifting value. The number of rows in the coupling parity matrix of the spatially coupled LDPC code is (L+M-1)*m, and the number of columns is L*n+(M-1)*m.

For the coupling parity matrix $H_{SC}$, the first parity-check sub-matrix $H_i^{(t)}$ with serial number i is determined by the first basic sub-matrix $Hb_i^{(t)}$ with serial number i and the lifting size. That is, the first sub-matrix $H_i^{(t)}$ with serial number i may be obtained by replacing the elements indicating the all-zero square matrix in the first basic sub-matrix $Hb_i^{(t)}$ with serial number i with the all-zero square matrix of size Z rows by Z columns, and replacing the elements indicating a cyclically shifted identity matrix with a matrix obtained by cyclically shifting an identity matrix of size Z rows by Z columns, where i = 0, 1, ..., M-1 and t = 0, 1, ..., L-1.

For the coupling parity matrix $H_{SC}$, the second parity-check sub-matrix $T_j$ with serial number j is determined by the second basic sub-matrix $Tb_j$ and the lifting size Z. That is, $T_j$ may be obtained by replacing the elements indicating the all-zero square matrix in the second basic sub-matrix $Tb_j$ with an all-zero square matrix of size Z rows by Z columns, and replacing the elements indicating a cyclically shifted identity matrix with a matrix obtained by cyclically shifting an identity matrix of size Z rows by Z columns, where j = 0, 1, ..., M-1.

The encoding process of spatially coupled LDPC code is as follows: performing spatially coupled LDPC encoding on input information, to obtain an encoding sequence C and the encoding sequence satisfies an equation as follows: $H_{SC}$ × C=0, where C is the encoding sequence, 0 is an all-zero vector, and $H_{SC}$ is the coupling parity matrix.

The encoding sequence may include L+M code blocks, that is, L first code blocks (also referred to as the second bit subsequences hereinafter) and M second code blocks (also referred to as the third bit subsequences hereinafter) where a length of each first code block of the L first code blocks is equal to n, and a length of each second code block of the M second code blocks is equal to m. In the spatially coupled LDPC encoding sequence, the t-th code block corresponds to a group of sub-matrices $H_0^{(t)}$, ..., $H_{m_s}^{(t)}$ that are not all equal to 0 in the coupled parity-check matrix $H_{SC}$. The top-left first element of $H_0^{(t)}$ is located at the row index t*m and column index t*n in $H_{SC}$, where t is a non-negative integer less than L. The j-th second code block in the spatially coupled LDPC encoding sequence corresponds to a sub-matrix $T_j$ that is not all equal to 0 in the coupled parity-check matrix $H_{SC}$. The top-left first element of $T_j$ is located at the row index t*m and column index t*n in $H_{SC}$, where t is a non-negative integer less than L. Unless otherwise specified, all variables in the embodiments of the present disclosure are numbered starting from 0.

Step S402 is introduced specifically for different structures of spatially coupled LDPC.

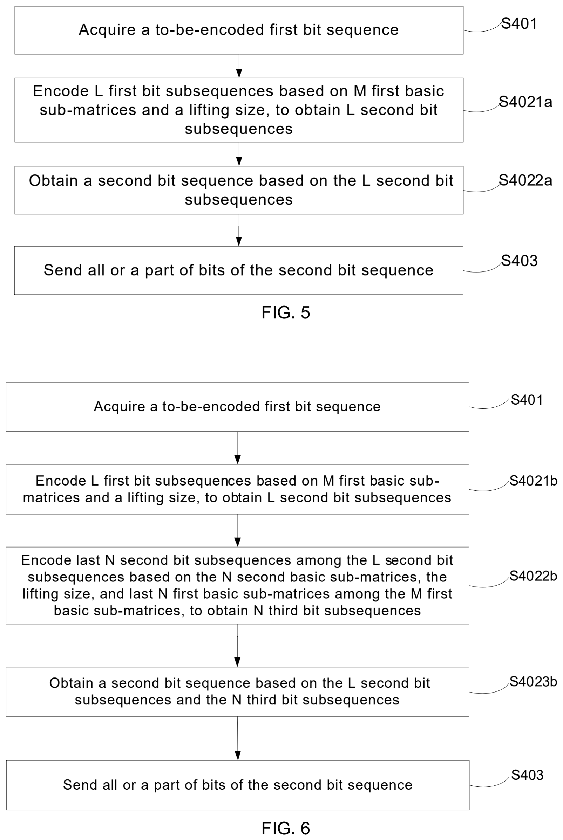

I. In a case where the basic matrix of spatially coupled LDPC only includes L basic sub-matrix groups, as shown in FIG. 5, S402 may be specifically implemented as steps S4021a-S4022a as follows:

In S4021a, L first bit subsequences are encoded based on M first basic sub-matrices and a lifting size, to obtain L second bit subsequences.

Herein, the first bit sequence includes L first bit subsequences. The second bit subsequence may have other names, such as the encoded bit subsequence, which is not limited thereto.

Exemplarily, the L first bit subsequences may be described as $\{a_0, a_1, ..., a_{L-1}\}$, a length of each first bit subsequence a is k bits, where k is a positive integer and a is a column vector. The second bit subsequence obtained by encoding the L first bit subsequences may be described as $\{b_0, b_1, ..., b_{L-1}\}$, a length of each second bit subsequence b is n bits, where n is a positive integer greater than or equal to k, and b is a column vector. The M first basic sub-matrices may be represented as $Hb_0, Hb_1, ..., Hb_{M-1}$, respectively.

For the first bit subsequence with serial number t (for example, described as at), the first bit subsequence $a_t$ is encoded in accordance with the M first basic sub-matrices and the lifting value, to obtain the second bit subsequence $b_t$ with serial number t.

First, according to the M first basic sub-matrices ($Hb_0, Hb_1, ..., Hb_{M-1}$) and the lifting value, the M parity-check sub-matrices are respectively determined as $H_0, H_1, ..., H_{M-1}$, that is, replacing the first element in the first basic sub-matrix with a Z × Z all-zero square matrix, and replacing the second element in the first basic sub-matrix with a cyclically shifted matrix of a Z × Z identity matrix. It should be understood that, each parity-check sub-matrix includes a replaced system column matrix $H^S$ and a replaced parity column matrix $H^P$. Then, the first bit subsequence is encoded based on $H^S$ and $H^P$ in the M parity-check sub-matrices. The specific process of encoding is as follows:

(1) In a case where t is equal to 0, the first bit subsequence with serial number 0 is encoded based on the first basic sub-matrix $Hb_0$ with serial number 0 and the lifting value, to obtain the second bit subsequence with serial number 0. Specifically, the parity-check sub-matrix $H_0$ determined by the first basic sub-matrix $Hb_0$ with serial number 0 and the lifting value is calculated as follows:

$$v = H_0^s \times a_0, \quad p = \left(H_0^p\right)^{-1} \times v$$

Therefore, the second bit subsequence with serial number 0 may be represented as $b_0 = \begin{bmatrix} a_0 \\ p \end{bmatrix}$, where $H_0^s$ and $H_0^p$ are the system column matrix and parity column matrix after replacement in the first parity-check sub-matrix with serial number 0, respectively.

(2) In a case where t is equal to 1, the first bit subsequence $a_1$ with serial number 1 is encoded, based on the first basic sub-matrix $Hb_0$ with serial number 0, the first basic sub-matrix $Hb_1$ with serial number 1 and the lifting size, to obtain the second bit subsequence $b_1$ with serial number 1. Specifically, the first sub-basic matrix $Hb_0$ with serial number 0, the first basic sub-matrix $Hb_1$ with serial number 1, and the lifting value, determine the first parity-check sub-matrices $H_0$ and $H_1$, and perform the following calculations:

$$v = (H_1 \times b_0) + (H_0^s \times a_1), \quad p = \left(H_0^p\right)^{-1} \times v$$

Therefore, the second bit subsequence with serial number 1 may be represented as $b_1 = \begin{bmatrix} a_1 \\ p \end{bmatrix}$.

(3) In a case where t is less than M, the first bit subsequence $a_t$ with serial number t is encoded based on t first basic sub-matrices, $Hb_0, ..., Hb_t$ in the M first basic sub-matrices, and the lifting size, to obtain the second bit subsequence $b_t$ with serial number t. The specific calculations are as follows:

$$v = \sum_{i=0}^{t-1} (H_{t-i} \times b_i) + (H_0^s \times a_t), \quad p = \left(H_0^p\right)^{-1} \times v$$

Therefore, the second bit subsequence $b_t$ may be represented as $b_t = \begin{bmatrix} a_t \\ p \end{bmatrix}$.

(4) In a case where t is greater than or equal to M, the first bit subsequence $a_t$ with serial number t is encoded based on the M first basic sub-matrices $Hb_0, ..., Hb_{M-1}$, and the lifting size, to obtain the second bit subsequence $b_t$ with serial number t. The specific calculations are as follows:

$$v = \sum_{i=0}^{M-1} (H_{M-1-i} \times b_{t-M+i+1}) + (H_0^s \times a_t) \;, \quad p = (H_0^p)^{-1} \times v$$

Therefore, the second bit subsequence $b_t$ may be represented as $b_t = \begin{bmatrix} a_t \\ p \end{bmatrix}$.

In S4022a, a second bit sequence is obtained based on the L second bit subsequences.

As a possible implementation, the second bit sequence is obtained by concatenating the L second bit subsequences.

II. In a case where the basic matrix of the spatially coupled LDPC includes L basic sub-matrix groups and N second basic sub-matrices, as shown in FIG. 6, S402 may be specifically implemented as steps S4021b- S4023b as follows:

In S4021b, L first bit subsequences are encoded based on M first basic sub-matrices and a lifting size, to obtain L second bit subsequences.

Herein, for the specific implementation of Step S4021b, reference may be made to the description of Step S4021a, which will not be repeated herein.

In S4022b, last N second bit subsequences among the L second bit subsequences are encoded based on the N second basic sub-matrices, the lifting size, and last N first basic sub-matrices among the M first basic sub-matrices, to obtain N third bit subsequences.

N third bit subsequences may be described as $\{c_0, c_1, ..., c_{N-1}\}$, a length of each third bit subsequence is n-k, where n is the length of the first bit subsequence and k is the length of the second bit subsequence. The N second basic sub-matrices may be described as $(Tb_0, Tb_1, ..., Tb_{N-1})$.

It should be understood that, according to the N second basic sub-matrices $(Tb_0, Tb_1, ..., Tb_{N-1})$ and the lifting value, the N parity-check sub-matrices are respectively determined as $T_0, T_1, ..., T_{N-1}$, that is, replacing the first element in the second basic sub-matrix with a $Z \times Z$ all-zero square matrix, and replacing the second element in the second basic sub-matrix with a cyclically shifted matrix of a $Z \times Z$ identity matrix.

The encoding process of the third bit subsequence $c_s$ with serial number s is as follows:

$$v = \sum_{i=1}^{N-s} (H_i \times b_{L-i}) \;, \quad c_s = (T_s)^{-1} \times v$$

Herein, $H_i$ represents an i-th parity-check sub-matrix among the last N first parity-check sub-matrices, and $b_{L-i}$ represents an (L-i)-th second bit subsequence among the last N second bit subsequences.

In some embodiments, if the N second parity-check sub-matrices respectively are $T_0, T_1, ..., T_{N-1}$, and all are identity matrices, then there is no need to perform inversion (the inverse matrix of the identity matrix is itself), i.e., $c_s = v$.

In S4023b, the second bit sequence is obtained based on the L second bit subsequences and the N third bit subsequences.

As a possible implementation, the L second bit subsequences and N third bit subsequences are concatenated sequentially, to obtain the second bit sequence.

It may be seen that, in a case where the basic matrix of spatially coupled LDPC also includes N second basic sub-matrices, the second bit sequence also includes N third bit subsequences, which may provide the receiving end with more prior information, and help the receiving end to correct errors in the received bit sequence.

The structure of the matrix will be explained below with reference to specific examples and drawings of the specification.

I. Raptor-like structure

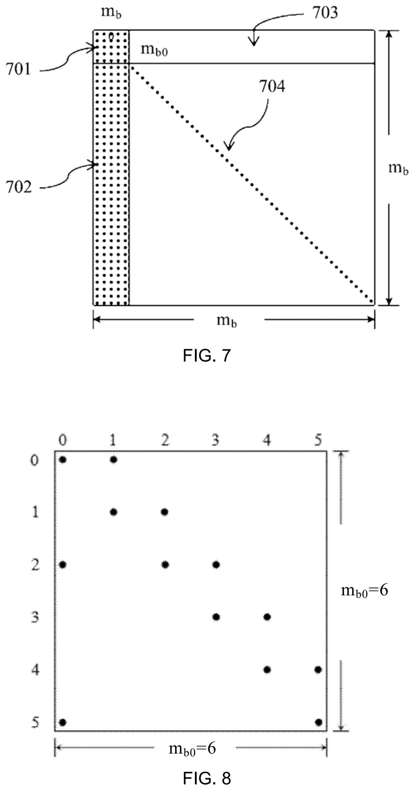

FIG. 7 is a schematic diagram of a Raptor-like structure, provided by the embodiments of the present disclosure. In FIG. 7, dots in the figure represent the second element, and the remaining blank spaces represent the first element. It should be understood that, the dots in the figure are merely schematic examples, where the corresponding area is a dot, which only indicates that the area has the second element, not that all elements in the area are the second element. The examples in the following respective figures also have this feature, which will not be repeated below.

As shown in FIG. 7, the parity column matrix with the Raptor-like structure has the following features:

1. The sub-matrix 701 formed by the top-left $m_{b0}$ rows and $m_{b0}$ columns have a row weight greater than 1 and a column weight greater than 1;

2. There are columns with column weights greater than 0 in the sub-matrix 702 formed by the lower-left $m_b$-$m_{b0}$ rows and $m_{b0}$ columns;

3. All elements in the sub-matrix 703 formed by the top-right $m_{b0}$ rows and $m_b$ -$m_{b0}$ columns are the first elements;

4. The elements on the diagonal are all second elements, and the elements in the remaining positions are all first elements in the sub-matrix 704 formed by the lower-right $m_b$-$m_{b0}$ rows and $m_b$ - $m_{b0}$ columns.

Herein, $m_{b0}$ is a positive integer less than or equal to n$_b$.

In an example, the second feature (i.e., there are columns with column weights greater than 0 in the sub-matrix 702 formed by the lower-left $m_b$-$m_{b0}$ rows and $m_{b0}$ columns) may be changed to: there may also be no column with a column weight greater than 0 in the sub-matrix 702 formed by the lower-left $m_b$-$m_{b0}$ rows and $m_{b0}$ columns.

It can be understood that, the advantage of having the parity column matrix with the Raptor-like structure in the first basic sub-matrix is that when calculating the parity bits of the corresponding first $m_{b0}$ columns, an inversion operation is required, while when calculating the parity bits of the corresponding last $m_b$ - $m_{b0}$ columns, a matrix inversion operation is not required, which reduces the dimension of the matrix that needs to be inverted, simplifies the encoding operation, lowers the encoding complexity, and enables fast encoding.

In some embodiments, for the first basic sub-matrix of the parity column matrix with the Raptor-like structure, the matrix formed by the top-left $m_{b0}$ rows and kb+$m_{b0}$ columns of the first basic sub-matrix may be referred to as the core matrix (kb is the number of columns in the system column matrix). The weight of any row in the core matrix is greater than 1, and the weight of any column is greater than 1 and furthermore, all elements in the matrix formed by the top-right $m_{b0}$ rows and $m_b$-$m_{b0}$ columns of the first basic sub-matrix all are first elements.

In some embodiments, the sub-matrix 701 formed by the top-left m$_{b0}$ rows and m$_{b0}$ columns of the parity column matrix with the Raptor-like structure are the double-diagonal structure matrices.

1. The i-th element and the mod (i+1, $m_{b0}$)-th element in the i-th row are both the second element and equal to 0, where i = 0, 1, 2, ..., $m_{b0}$-1;

2. There is a second element that is not equal to 0 among the second element to the ($m_{b0}$)-th element in the first column. For example, the column weight of the first column is 3.

It can be understood that, if the sub-matrix 701 formed by the top-left $m_{b0}$ rows and $m_{b0}$ columns of the parity column matrix is a double-diagonal structure matrix, then when encoding and calculating the parity bits of the corresponding first $m_{b0}$ columns, there is no need to perform an inversion operation on the sub-matrix 701, which may lower the encoding complexity.

As an example, FIG. 8 shows a schematic diagram of a double-diagonal structure, provided by the embodiments of the present disclosure. As shown in FIG. 8, the $m_{b0}$ is equal to 6, where the dots represent the second element and the remaining blank spaces represent the first element. The numbers at the top of the figure (0 to 5) are column indices, and the numbers on the far left (0 to 5) are row indices.

In some examples, $m_{b0}$ may be equal to 3, 4, 5, 6, 7 or 8.

In some examples, $m_{b0}$ may be equal to $m_b$, in which case the parity column matrix with the Raptor-like structure is the core matrix, or a matrix with a double-diagonal structure.

II. Identity matrix structure

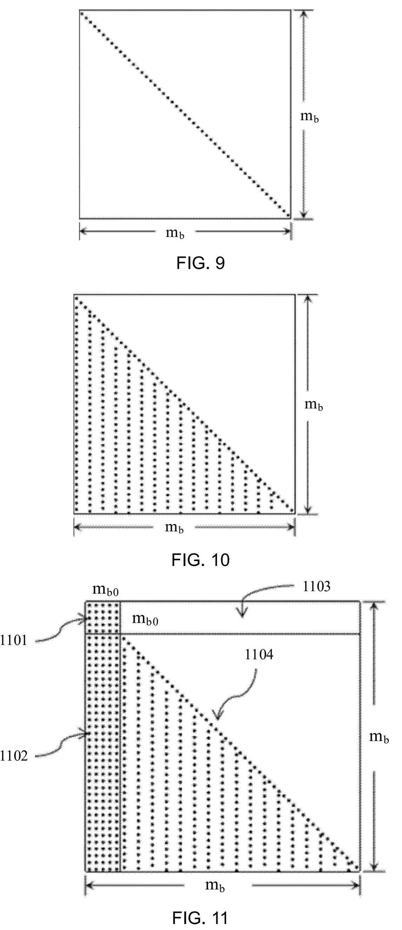

FIG. 9 is a schematic diagram of an identity matrix structure, provided by the embodiments of the present disclosure, that is, all diagonal elements in the parity column matrix with the identity matrix structure are second elements. As shown in FIG. 9, the dots represent the second element, and the remaining blank spaces represent the first element. If the first basic sub-matrix is the parity column matrix with the identity matrix structure, the encoding process is very simple, the calculation of all parity bits does not require an inversion operation, the complexity is very low, and parallel calculation may be performed to further improve the speed of the encoding operation.

In an example, the values of all elements on the diagonal of the parity column matrix with the identity matrix structure are equal to 0 (i.e., all elements on the diagonal indicate an identity matrix).

III. Lower triangular structure

FIG. 10 is a schematic diagram of a lower triangular structure, provided by the embodiments of the present disclosure. As shown in FIG. 10, the dots represent the second element, and the remaining blank spaces represent the first element. A parity column matrix with a lower triangular structure has the following features:

1. All elements on the diagonal are the second elements.

2. There is at least one second element among all elements below the diagonal.

It can be understood that, the advantage of having the parity column matrix with the lower triangular structure in the first basic sub-matrix is that the calculation of all parity bits does not require an inversion operation, which simplifies the encoding operation, lowers encoding complexity, and enables fast encoding.

In an example, all elements on the diagonal of the parity column matrix with the lower triangular structure are equal to 0.

In an example, all elements indicating cyclic shifts of the identity matrix in the parity column matrix with the lower triangular structure are equal to 0.

In an example, all elements on the diagonal of the parity column matrix with the lower triangular structure are elements indicating cyclic shifts of the identity matrix, and the elements indicated by the row and column indices $\{i+1, i\}$ corresponding to any integer i in the parity column matrix are elements indicating cyclic shifts of the identity matrix, where i is any non-negative integer less than $m_{b1}$, $m_{b1}$ is less than or equal to $m_b$, and $m_b$ is the number of rows of the parity column matrix and the remaining elements are elements indicating the all-zero square matrix. In a specific example, the $m_{b1}$ is equal to 2, 3, 4, 5, 6, 7, or 8.

IV. Quasi-lower triangular structure

FIG. 11 is a structural schematic diagram of a quasi-lower triangular structure, provided by the embodiments of the present disclosure. As shown in FIG. 11, the dots represent the second element, and the remaining blank spaces represent the first element. A parity column matrix with a quasi-lower triangular structure has the following features:

1. The sub-matrix 1101 formed by the top-left $m_{b0}$ rows and $m_{b0}$ columns has a row weight greater than 1 and a column weight greater than 1;

2. The column weight of the sub-matrix 1102 formed by the lower-left $m_b$-$m_{b0}$ rows and $m_{b0}$ columns is also greater than 0;

3. All elements in the sub-matrix 1103 formed by the top-right $m_{b0}$ rows and $m_b$ -$m_{b0}$ columns are the elements indicating the all-zero square matrix;

4. The sub-matrix 1104 formed by the lower-right $m_b$ -$m_{b0}$ rows and $m_b$ -$m_{b0}$ columns has a lower triangular structure.

It can be understood that, the advantage of having the parity column matrix with the quasi-lower triangular structure in the first basic sub-matrix is that when calculating the parity bits of the corresponding first $m_{b0}$ columns, an inversion operation is required, while when calculating the parity bits of the corresponding last $m_b$ -$m_{b0}$ columns, a matrix inversion operation is not required, and it may be seen that the dimension of the matrix that needs to be inverted is reduced, which may simplify the encoding operation, lower the encoding complexity, and enable fast encoding.

In addition, the sub-matrix 1101 formed by the top-left $m_{b0}$ rows and $m_{b0}$ columns may be a double-diagonal structure matrix mentioned in the aforementioned Raptor-like structure.

Herein, $m_{b0}$ is a positive integer less than $n_b$. In an example, $m_{b0}$ is equal to 3, 4, 5, 6, 8 or 10. $m_b$ is an integer greater than $m_{b0}+4$.

V. First preset structure

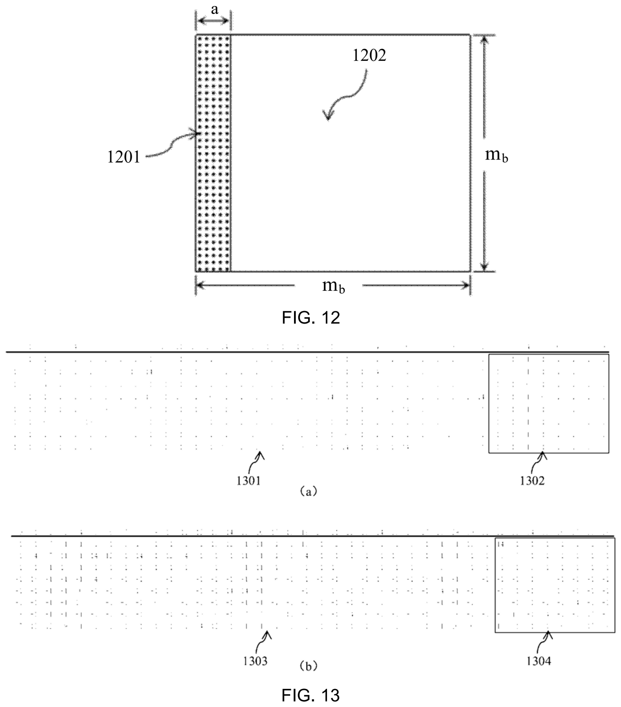

In the first preset structure of the parity column matrix, column weights of the first a columns are greater than 0, and column weights of remaining columns are equal to 0, where a is a positive integer. FIG. 12 is a structural schematic diagram of a parity column matrix adopting a first preset structure, provided by the embodiments of the present disclosure. As shown in FIG. 12, the dots represent the second element, and the remaining blank spaces represent the first element. The column weight of each column in sub-matrix 1201 formed by the first a columns is greater than 0, and the column weight of each column in sub-matrix 1202 formed by the last $(m_b - a)$ columns is equal to 0.

VI. Second preset structure

In the second preset structure of the parity column matrix, all elements are the first elements, and the first element is used to indicate the all-zero square matrix.

The structure of the first basic sub-matrix described above will be exemplarily explained below in detail with reference to specific examples and drawings of the specification.

Example 1

In this example, taking an example of M equal to 2, the first bit subsequence is encoded based on the two first basic sub-matrices and the lifting size, to obtain the second bit subsequence and the two first basic sub-matrices are $Hb_0$ and $Hb_1$ , respectively.

Among the two first basic sub-matrices, the parity column matrix of one first basic sub-matrix has an identity matrix structure, and the parity column matrix of another first basic sub-matrix has a lower triangular matrix structure. For example, the parity column matrix of the first first basic sub-matrix $Hb_0$ has an identity matrix structure, and the parity column matrix of the second first basic sub-matrix $Hb_1$ has a lower triangular structure.

FIG. 13 is a structural schematic diagram of a first basic sub-matrix, provided by the embodiments of the present disclosure, as shown in FIG. 13, (a) in FIG. 13 corresponds to the first first basic sub-matrix $Hb_0$, and (b) in FIG. 13 corresponds to the second first basic sub-matrix $Hb_1$, the numbers in the first row represent column indices (0 ~ 39), the dimensions of the two first basic sub-matrices are both 8 rows and 40 columns, the sub-matrix 1301 and sub-matrix 1303 are system column matrices of $Hb_0$ and $Hb_1$ respectively, and sub-matrix 1302 and sub-matrix 1304 are the parity column matrices of $Hb_0$ and $Hb_1$ respectively. The first basic sub-matrix includes two types of elements: "-1" element represents an element indicating the all-zero square matrix (first element); non-"-1" element represents an element indicating the cyclic shift of the identity matrix (second element). Herein, the non-"-1" elements are all non-negative integers, which describe the number of bits of the identity matrix cyclic shift. It may be seen that, the parity column matrix 1302 of the first basic sub-matrix $Hb_0$ is a matrix of 8 rows and 8 columns with an identity matrix structure. Only the elements on the diagonal are equal to 0, and the remaining elements are equal to -1. The parity column matrix 1304 of the first basic sub-matrix $Hb_1$ is an 8-row and 8-column matrix with a lower triangular structure. The elements on the diagonal are second elements, and there is at least one second element below the diagonal. In this example, the lifting size is equal to 16.

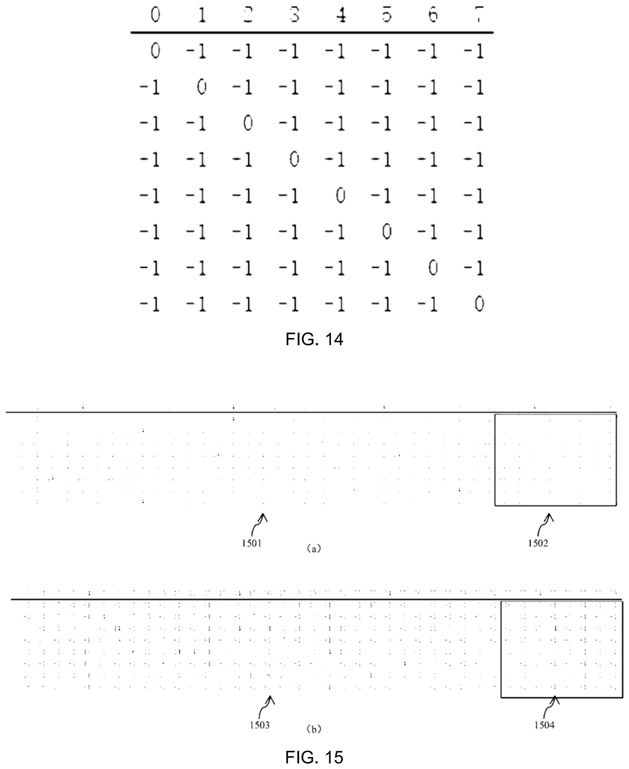

In addition, in this example, there is a second basic sub-matrix, as shown in FIG. 14, the second basic sub-matrix adopts the identity matrix structure, where only the elements on the diagonal are second elements, and the value of the second element is equal to 0.

Example 2

The difference between this example and Example 1 is that the M first basic sub-matrices used are different. In this example, taking an example of M equal to 2, among the M first sub-basic matrices used, the parity column matrix of one first basic sub-matrix has a Raptor-like structure, and the parity column matrix of another first basic sub-matrix has the following features: the column weights of the first a columns being greater than 0, and the column weights of the remaining columns being equal to 0, where a is a positive integer. Herein, the sub-matrix formed by the top-left $m_{b0}$ rows and $m_{b0}$ columns of the parity column matrix with the Raptor-like structure is a double-diagonal structure matrix, where a equals to $m_{b0}$ and $m_{b0}$ is an integer greater than 1.

Exemplarily, taking an example in which the $m_{b0}$ is equal to 4, a is equal to 4, M is equal to 2, and 2 first basic sub-matrix respectively are $Hb_0$ and $Hb_1$. Herein, the parity column matrix of the first first basic sub-matrix $Hb_0$ has the Raptor-like structure, and the parity column matrix of the second first basic sub-matrix $Hb_1$ has the following features: column weights of the first a columns are greater than 0, the column weights of the remaining columns are equal to 0, and a is an integer greater than 0.

FIG. 15 is a structural schematic diagram of another first basic sub-matrix, provided by the embodiments of the present disclosure, as shown in FIG. 15, (a) in FIG. 15 corresponds to the first first basic sub-matrix $Hb_0$, and (b) in FIG. 15 corresponds to the second first basic sub-matrix $Hb_1$. The numbers in the first row of the figure represent column indices (0 ~ 39), dimensions of the two first basic sub-matrices are 8 rows × 40 columns, where sub-matrix 1501 and sub-matrix 1503 are the systematic column matrices of $Hb_0$ and $Hb_1$ respectively, and sub-matrix 1502 and sub-matrix 1504 are the parity column matrices of $Hb_0$ and $Hb_1$, respectively.

It may be seen that, the parity column matrix 1502 of the first first basic sub-matrix $Hb_0$ is a matrix of 8 rows and 8 columns with the Raptor-like structure, i.e., $m_{b0}$ =4, the row weights and the column weights of the sub-matrix formed by the top-left 4 rows and 4 columns are all greater than 1, the row weights are 2 and 3, respectively, and the column weights are 2 and 3, respectively; the sub-matrix formed by the lower-left 4 rows and 4 columns has columns with column weights greater than 0, all elements in the sub-matrix formed by the top-right 4 rows and 4 columns are first elements, the elements on the diagonal in the sub-matrix formed by the lower-right 4 rows and 4 columns are second elements, and the remaining elements are first elements, i.e., it has the identity matrix structure. The sub-matrix formed by the top-left 4 rows and 4 columns in the parity column matrix with the Raptor-like structure is a double-diagonal structure matrix.

The parity column matrix 1504 of the second first basic sub-matrix $Hb_1$ is a matrix of 8 rows and 8 columns with the following features: the column weights of the first a columns being greater than 0, the column weights of the remaining columns being equal to 0, and a is equal to 4. In this example, the lifting size is equal to 16.

Example 3

In this example, taking an example in which M is equal to 2, the parity column matrices of the two first basic sub-matrices used both have the Raptor-like structure. The parity column matrix has the following features: the sub-matrix formed by the top-left $m_{b0}$ rows and $m_{b0}$ columns is a double-diagonal structure matrix, where $m_{b0}$ is equal to 4.

Exemplarily, taking an example in which the two first basic sub-matrices are $Hb_0$ and $Hb_1$, respectively, both the first first basic sub-matrix $Hb_0$ and second first basic sub-matrix $Hb_1$ have the Raptor-like structure.

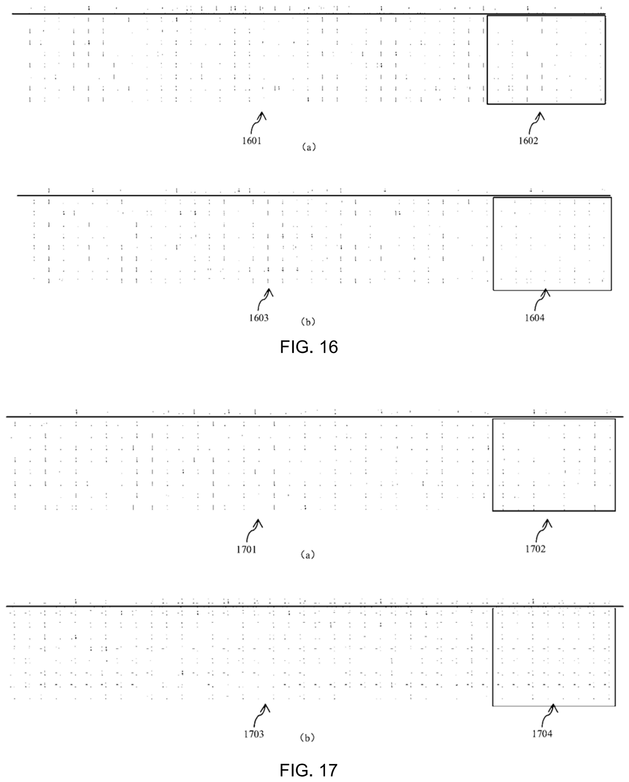

FIG. 16 is a structural schematic diagram of yet another first basic sub-matrix, provided by the embodiments of the present disclosure, as shown in FIG. 16, (a) in FIG. 16 corresponds to the first first basic sub-matrix $Hb_0$, and (b) in FIG. 16 corresponds to the second first basic sub-matrix $Hb_1$. The numbers in the first row of the figure represent column indices (0 ~ 39), dimensions of the two first basic sub-matrices are 8 rows and 40 columns, where sub-matrix 1601 and sub-matrix 1603 are the systematic column matrices of $Hb_0$ and $Hb_1$, respectively, and sub-matrix 1602 and sub-matrix 1604 are the parity column matrices of $Hb_0$ and $Hb_0$, respectively. As may be seen from FIG. 16, the parity column matrices of the two first basic sub-matrices both have the Raptor-like structure. In this example, the lifting size is equal to 16.

Example 4

In this example, taking an example in which M is equal to 2, among the two first basic sub-matrices used, the parity column matrix of one first basic sub-matrix has a Raptor-like structure, and the parity column matrix of another first basic sub-matrix has the following features: all elements being the first elements. The parity column matrix with the Raptor-like structure has the following features: the sub-matrix formed by the top-left $m_{b0}$ rows and $m_{b0}$ columns is a double-diagonal structure matrix, where $m_{b0}$ is equal to 4.

For example, taking an example in which the two first basic sub-matrices are $Hb_0$ and $Hb_1$, respectively, the first basic sub-matrix $Hb_0$ has the Raptor-like structure, and all elements in the first basic sub-matrix $Hb_1$ are first elements.

FIG. 17 is a structural schematic diagram of yet another first basic sub-matrix, provided by the embodiments of the present disclosure, as shown in FIG. 17, (a) in FIG. 17 corresponds to the first basic sub-matrix $Hb_0$, and (b) in FIG. 16 corresponds to the first basic sub-matrix $Hb_1$. The numbers in the first row of the figure represent column indices (0 ~ 39), dimensions of the two first basic sub-matrices are 8 rows and 40 columns, where sub-matrix 1701 and sub-matrix 1703 are the systematic column matrices of $Hb_0$ and $Hb_1$, respectively, and sub-matrix 1702 and sub-matrix 1704 are the parity column matrices of $Hb_0$ and $Hb_0$, respectively. As may be seen from FIG. 17, the parity column matrix of the first basic sub-matrix $Hb_0$ has the Raptor-like structure, and all elements in the parity column matrix of the first basic sub-matrix $Hb_0$ are the first elements. In this example, the lifting size is equal to 16.

Example 5

In this example, taking an example in which M is equal to 2, in the two first basic sub-matrices used, the parity column matrix of the one first basic sub-matrix has the identity matrix structure.

Exemplarily, taking an example in which the 2 first basic sub-matrices are $Hb_0$ and $Hb_1$, respectively, the 2 first basic sub-matrices have the identity matrix structure.

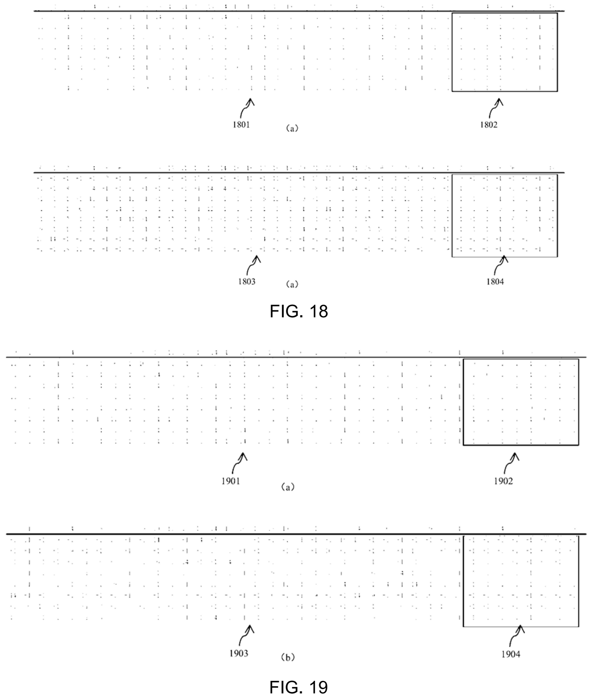

FIG. 18 is a structural schematic diagram of yet another first basic sub-matrix, provided by the embodiments of the present disclosure, as shown in FIG. 18, (a) in FIG. 18 corresponds to the first basic sub-matrix $Hb_0$, and (b) in FIG. 18 corresponds to the first basic sub-matrix $Hb_1$. The numbers in the first row of the figure represent column indices (0 ~ 39), dimensions of the two first basic sub-matrices are 8 rows and 40 columns, where sub-matrix 1801 and sub-matrix 1803 are the systematic column matrices of $Hb_0$ and $Hb_1$, respectively, and sub-matrix 1802 and sub-matrix 1804 are the parity column matrices of $Hb_0$ and $Hb_0$, respectively. As may be seen from FIG. 18, the parity column matrix of the first basic sub-matrix $Hb_0$ has the identity matrix structure, and the parity column matrix of the first basic sub-matrix $Hb_1$ has the identity matrix structure. In this example, the lifting size is equal to 16.

Example 6

In this example, taking an example in which M is equal to 2, among the 2 first basic sub-matrices used, the parity column matrix of one first basic sub-matrix has an identity matrix structure, and the parity column matrix of another first basic sub-matrix has the following features: all elements being the first elements.

For example, taking an example in which the two first basic sub-matrices are $Hb_0$ and $Hb_1$, respectively, the first basic sub-matrix $Hb_0$ has the identity matrix structure, and all elements in the first basic sub-matrix $Hb_1$ are first elements.

FIG. 19 is a structural schematic diagram of yet another first basic sub-matrix, provided by the embodiments of the present disclosure, as shown in FIG. 19, (a) in FIG. 19 corresponds to the first basic sub-matrix $Hb_0$, and (b) in FIG 19 corresponds to the first basic sub-matrix $Hb_1$. The numbers in the first row of the figure represent column indices (0 ~ 39), dimensions of the two first basic sub-matrices are 8 rows and 40 columns, where sub-matrix 1901 and sub-matrix 1903 are the systematic column matrices of $Hb_0$ and $Hb_1$, respectively, and sub-matrix 1902 and sub-matrix 1904 are the parity column matrices of $Hb_0$ and $Hb_0$, respectively. As may be seen from FIG. 19, the parity column matrix of the first basic sub-matrix $Hb_0$ has the identity matrix structure, and all elements in the parity column matrix of the first basic sub-matrix $Hb_0$ are the first elements. In this example, the lifting size is equal to 16.

Example 7

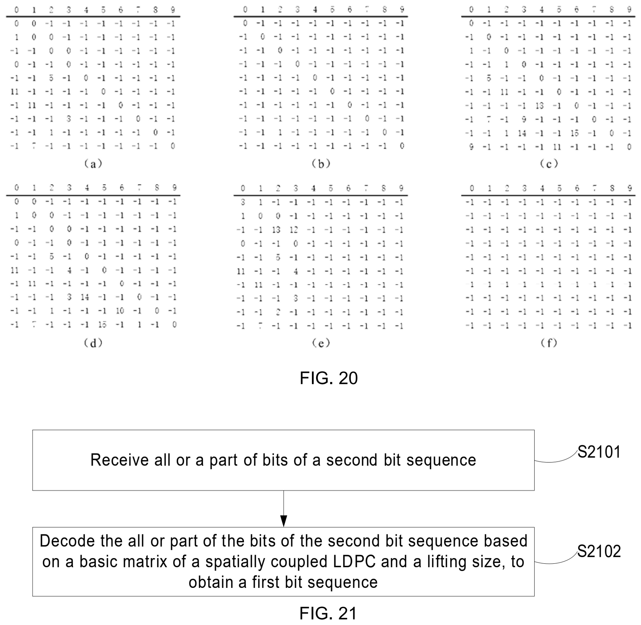

FIG. 20 is a schematic diagram of a structure of a parity column matrix, provided by the embodiments of the present disclosure.

As shown in FIG. 20. In this example, in the parity column matrix, the number of rows of is 10 and the number of columns is 10. FIG. 20 shows six types of structures of parity column matrices, which respectively correspond to: (a) a parity column matrix with a Raptor-like structure; (b) a parity column matrix with an identity matrix structure; (c) a parity column matrix with a lower triangular structure; (d) a parity column matrix with a quasi-lower triangular structure; (e) a parity column matrix in which the column weights of the first a columns are greater than 0 and the column weights of the remaining columns are equal to 0, where a is equal to 4; (f) all elements in the parity column matrix being the first elements. The lifting size may be equal to 16.

In an example, the two first basic sub-matrices are $Hb_0$ and $Hb_1$, respectively, the parity column matrix of the first basic sub-matrix $Hb_0$ has a Raptor-like structure, and the parity column matrix of the first basic sub-matrix $Hb_1$ has the identity matrix structure.

In another example, the two first basic sub-matrices are $Hb_0$ and $Hb_1$, respectively, the parity column matrix of the first basic sub-matrix $Hb_0$ has a Raptor-like structure, and the parity column matrix of the first basic sub-matrix $Hb_1$ has a lower triangular structure.

In yet another example, the two first basic sub-matrices are $Hb_0$ and $Hb_1$, respectively, the parity column matrix of the first basic sub-matrix $Hb_0$ has a Raptor-like structure, and the parity column matrix of the first basic sub-matrix $Hb_1$ has a quasi-lower triangular structure.

In yet another example, the two first basic sub-matrices are $Hb_0$ and $Hb_1$, respectively, the parity column matrix of the first basic sub-matrix $Hb_0$ has a quasi-lower triangular structure, and the parity column matrix of the first basic sub-matrix $Hb_1$ has the Raptor-like structure.

In yet another example, the two first basic sub-matrices are $Hb_0$ and $Hb_1$, respectively, the parity column matrix of the first basic sub-matrix $Hb_0$ has a quasi-lower triangular structure, and the parity column matrix of the first basic sub-matrix $Hb_1$ has the identity matrix structure.

In yet another example, the two first basic sub-matrices are $Hb_0$ and $Hb_1$, respectively, the parity column matrix of the first basic sub-matrix $Hb_0$ has a quasi-lower triangular structure, and the parity column matrix of the first basic sub-matrix $Hb_1$ has a quasi-lower triangular structure.

In yet another example, the two first basic sub-matrices are $Hb_0$ and $Hb_1$, respectively, the parity column matrix of the first basic sub-matrix $Hb_0$ has a quasi-lower triangular structure, and the column weights of the first a columns in the parity column matrix of the first basic sub-matrix $Hb_1$ is greater than 0, and the column weights of the remaining columns are equal to 0.

Additionally, exemplarily, in a case where a third bit subsequence is generated according to a second basic sub-matrix, the second basic sub-matrix may have a Raptor-like structure, or an identity matrix structure, or a lower triangular structure, or a quasi-lower triangular structure as shown in FIG. 20.

Example 8

In this example, taking an example in which M is equal to 3, the three first basic sub-matrices are $Hb_0$, $Hb_1$ and $Hb_2$, respectively. Among the three first basic sub-matrices used, the parity column matrix of at least one first basic sub-matrix has a Raptor-like structure, and/or the parity column matrix of at least one first basic sub-matrix has an identity matrix structure, and/or the parity column matrix of at least one first basic sub-matrix has a lower triangular structure.

In an example, a parity column matrix of a first first basic sub-matrix $Hb_0$ has a Raptor-like structure (as shown in (a) of FIG. 20), a parity column matrix of a second first basic sub-matrix $Hb_1$ has an identity matrix structure (as shown in (b) of FIG. 20), and a parity column matrix of a third first basic sub-matrix $Hb_2$ also has an identity matrix structure (as shown in (b) of FIG. 20).

In another example, the parity column matrix of the first first basic sub-matrix $Hb_0$ has a Raptor-like structure (as shown in (a) of FIG. 20), the parity column matrix of the second first basic sub-matrix $Hb_1$ has the following features: the column weights of the first a columns being greater than 0, and the column weights of the remaining columns being equal to 0 (as shown in (e) of FIG. 20), and the parity column matrix of the third first basic sub-matrix $Hb_2$ also has the following features: the column weights of the first a columns being greater than 0, and the column weights of the remaining columns being equal to 0 (as shown in (e) of FIG. 20). Herein, a may be equal to 3, 4, 5, 6 or 8, for example, a is equal to 4, that is, a is equal to the number of rows of the core matrix of the first first basic sub-matrix $Hb_0$.

In yet another example, the parity column matrix of the first first basic sub-matrix $Hb_0$ has identity matrix structure (as shown in (b) of FIG. 20), the parity column matrix of the second first basic sub-matrix $Hb_1$ has the following features: the column weights of the first a columns being greater than 0, and the column weights of the remaining columns being equal to 0 (as shown in (e) of FIG. 20), and the parity column matrix of the third first basic sub-matrix $Hb_2$ also has the following features: the column weights of the first a columns being greater than 0, and the column weights of the remaining columns being equal to 0 (as shown in (e) of FIG. 20). Herein, a may be equal to 3, 4, 5, 6, or 8.

Additionally, exemplarily, two second basic sub-matrices may further be included, the two second basic sub-matrices may have two of the following structures: the Raptor-like structure, the identity matrix structure, the lower triangular structure, and the quasi-lower triangular structure.

In an example, a parity column matrix of a first second basic sub-matrix $Tb_0$ has a Raptor-like structure (as shown in (a) of FIG. 20), and a parity column matrix of a second second basic sub-matrix $Tb_1$ has an identity matrix structure (as shown in (b) of FIG. 20).

In another example, the parity column matrix of the first second basic sub-matrix $Tb_0$ has a Raptor-like structure (as shown in (a) of FIG. 20), and the parity column matrix of the second second basic sub-matrix $Tb_1$ has a quasi-lower triangular structure (as shown in (d) of FIG. 20).

In yet another example, the parity column matrix of the first second basic sub-matrix $Tb_0$ has an identity matrix structure (as shown in (b) of FIG. 20), and the parity column matrix of the second second basic sub-matrix $Tb_1$ has a lower triangular structure (as shown in (c) of FIG. 20).

Yet exemplarily, the two second basic sub-matrices have an identical structure. For example, the second basic sub-matrix $Tb_0$ and $Tb_1$ both have a Raptor-like structure (as shown in (a) of FIG. 20) or an identity matrix structure (as shown in (b) of FIG. 20).

Example 9

In this example, taking an example in which M is equal to 4, the three first basic sub-matrices are $Hb_0$, $Hb_1$, $Hb_2$ and $Hb_3$, respectively. Among the four first basic sub-matrices used, the parity column matrix of the first basic sub-matrix $Hb_0$ has the following structures: 1. Raptor-like structure; 2. identity matrix structure; 3. lower triangular structure; 4. quasi-lower triangular structure. The remaining three first basic sub-matrices have one of the following structures: 1. Raptor-like structure; 2. identity matrix structure; 3. lower triangular structure; 4. quasi-lower triangular structure; 5. the column weights of the first a columns being greater than 0 and the column weights of the remaining columns being equal to 0, where a is an integer greater than 0; 6. all elements being first elements.

In an example, the parity column matrix of the first first basic sub-matrix $Hb_0$ has a Raptor-like structure (as shown in (a) of FIG. 20), and the parity column matrices of the second first basic sub-matrix to fourth first basic sub-matrix all have the following features: the column weights of the first a columns being greater than 0 and the column weights of the remaining columns being equal to 0, where a is equal to 4, or a lower triangular structure, or all elements being the first elements, or a quasi-lower triangular structure.

In another example, the parity column matrix of the first first basic sub-matrix $Hb_0$ has an identity matrix structure (as shown in (a) of FIG. 20), and the parity column matrices of the second first basic sub-matrix to fourth first basic sub-matrix all have the following features: the column weights of the first a columns being greater than 0 and the column weights of the remaining columns being equal to 0, where a is equal to 4, or a lower triangular structure, or all elements being the first elements, or a quasi-lower triangular structure.

Additionally, exemplarily, three second basic sub-matrices are further included, and are $Tb_0$, $Tb_1$ and $Tb_2$, respectively. The three second basic sub-matrices may have at least one of the following structures: the Raptor-like structure, the identity matrix structure, the lower triangular structure, or the quasi-lower triangular structure.

In an example, the parity column matrices of the three second basic sub-matrices all have the Raptor-like structure, or the identity matrix structure, or the lower triangular structure.

In another example, among the three second basic sub-matrices, the parity column matrix of the first second basic sub-matrix $Tb_0$ has the Raptor-like structure, the parity column matrix of the second second basic sub-matrix $Tb_1$ has the identity matrix structure, and the parity column matrix of the third second basic sub-matrix $Tb_2$ has the lower triangular structure.

In yet another example, among the three second basic sub-matrices, the parity column matrix of the first second basic sub-matrix $Tb_0$ has the Raptor-like structure, the parity column matrix of the second second basic sub-matrix $Tb_1$ has the identity matrix structure, and the parity column matrix of the third second basic sub-matrix $Tb_2$ has the identity matrix structure.

It should be understood that, any transformations made based on the examples described above (such as any transformation combination of the value of M, the structures of the first basic sub-matrix and second basic sub-matrix, etc.)

should be covered within the protection scope of the present disclosure.

As shown in FIG. 21, the embodiments of the present disclosure provide a decoding method, applied to a decoding apparatus and the method at least includes S2101 to S2102.

In S2101, all or a part of bits of a second bit sequence is received.

In S2102, the all or part of the bits of the second bit sequence is decoded based on a basic matrix of a spatially coupled LDPC and a lifting size, to obtain a first bit sequence.

Herein, for the relevant description of the basic matrix of the spatially coupled LDPC, reference may be made to the previous document, which will not be repeated herein.

In some embodiments, the decoding apparatus may adopt methods such as pipelined decoding or sliding window decoding, etc., to decode the all or part of the bits of the received second bit sequence.

In the embodiments of the present disclosure, the second bit sequence is generated based on the encoding mode of the spatially coupled LDCP. Therefore, decoding the all or part of the bits of the received second bit sequence results in low decoding complexity.

It should be understood that, the above-mentioned naming of matrices and bit sequences is merely exemplary, and different names may be used in different scenarios. For example, the second basic sub-matrix may also be named the tail basic sub-matrix, the first bit subsequence may also be named the information bit subsequence, the second bit subsequence may also be named the encoding bit subsequence, and the third bit subsequence may also be named the tail bit subsequence.

It can be understood that in order to achieve the functions mentioned above, an encoding apparatus and a decoding apparatus contain corresponding hardware structures and/or software modules for performing respective functions. Those skilled in the art should easily realize that, in combination with the exemplary algorithm steps described in the embodiments of the present disclosure, the present disclosure can be implemented in the form of hardware or a combination of hardware and computer software. Whether a certain function is executed by hardware or by computer software driving hardware, depends on the specific applications and design constraint conditions of the technical solutions. Professional technicians may use different methods to implement the described functions for each specific application, but such implementation should not be considered beyond the scope of the present disclosure.

In the embodiments of the present disclosure, the encoding apparatus or the decoding apparatus may be divided into functional modules according to the above-mentioned method embodiments, and for example, each functional module may be divided corresponding to each function, or two or more functions may be integrated into one functional module. The above-mentioned integrated module may be implemented in the form of hardware or may also be implemented in the form of software. It should be noted that the division of the modules in embodiments of the present disclosure is schematic, which is only a logical functional division, and there may be other divisions for in actual implementations. The example in which each functional module may be divided corresponding to each function is taken for explanation below.

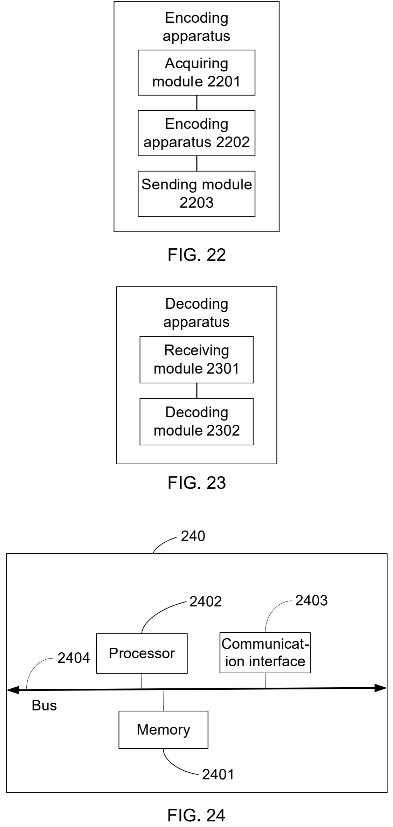

FIG. 22 is a structural schematic diagram of an encoding apparatus, provided in the embodiments of the present disclosure, and the encoding apparatus may perform the encoding method provided in the above method embodiments. As shown in FIG. 22, the encoding apparatus includes an acquiring module 2201, an encoding module 2202 and a sending module 2203.

The acquiring module 2201 is configured to acquire a to-be-encoded first bit sequence.

The encoding module 2202 is configured to encode the first bit sequence based on a basic matrix of a spatially coupled LDPC and a lifting size, to obtain a second bit sequence, where the basic matrix includes L basic sub-matrix groups that are identical and arranged diagonally, and the basic sub-matrix group includes M first basic sub-matrices, where L and M are both positive integers.

The sending module 2203 is configured to send all or a part of bits of the second bit sequence.

Herein, for the relevant description of the basic matrix of the spatially coupled LDPC, reference may be made to the previous document, which will not be repeated herein.

In some embodiments, the first bit sequence includes L first bit subsequences; the encoding module 2202 is specifically configured to encode the L first bit subsequences based on M first basic sub-matrices and the lifting size, to obtain L second bit subsequences; and obtain the second bit sequence based on the L second bit subsequences.

In some embodiments, the first bit sequence includes L first bit subsequences; the encoding module 2202 is specifically configured to: encode the L first bit subsequences based on the M first basic sub-matrices and the lifting size, to obtain L second bit subsequences; encode last N second bit subsequences among the L second bit subsequences based on the N second basic sub-matrices, the lifting size, and last N first basic sub-matrices among the M first basic sub-matrices, to obtain N third bit subsequences; and obtain the second bit sequence based on the L second bit subsequences and the N third bit subsequences.

FIG. 23 is a structural schematic diagram of a decoding apparatus, provided in the embodiments of the present disclosure, and the decoding apparatus may perform the decoding method provided in the above method embodiments. As shown in FIG. 23, the decoding apparatus includes: a receiving module 2301 and a decoding module 2302.

The receiving module 2301 is configured to receive all or a part of bits of a second bit sequence.

The decoding module 2302 is configured to, decode the all or part of bits of the second bit sequence based on a basic matrix of a spatially coupled low-density parity-check code (LDPC) and a lifting size, to obtain a first bit sequence, where the basic matrix includes L basic sub-matrix groups that are identical and arranged diagonally, and the basic sub-matrix group includes M first basic sub-matrices, where L and M are both positive integers.

Herein, for the relevant description of the basic matrix of the spatially coupled LDPC, reference may be made to the previous document, which will not be repeated herein.

In a case of implementing the functions of the integrated modules mentioned above in the form of hardware, the embodiments of the present disclosure provide another possible structure of a communication apparatus (may be the above encoding apparatus or the decoding apparatus) involved in the above embodiments. As shown in FIG. 24, the communication apparatus 240 includes a processor 2402 and a bus 2404. Optionally, the communication apparatus may further include a memory 2401; and optionally, the communication apparatus may further include a communication interface 2403.

The processor 2402 may implement or execute various illustrative logical blocks, modules and circuits described in conjunction with the embodiments of the present disclosure. The processor 2402 may be a central processing unit, a general-purpose processor, a digital signal processor, an application specific integrated circuit, a field programmable gate array or any other programmable logic device, a transistor logic device, a hardware component, or any combination thereof. The processor 2402 may implement or execute various illustrative logical blocks, modules and circuits described in conjunction with the embodiments of the present disclosure. The processor 2402 may also be a combination that implements computing functions, for example, including a combination of one or more microprocessors, a combination of a digital signal processor (DSP) and a microprocessor, or the like.

The communication interface 2403 (may also be referred to as a transmitter) is configured to connect with other devices via a communication network. The communication network may be an Ethernet, a radio access network, a wireless local area network (WLAN), or the like.

The memory 2401 may be, but be not limited to, a read-only memory (ROM) or other types of static storage devices capable of storing static information and instructions, a random access memory (RAM) or other types of dynamic storage devices capable of storing information and instructions, or may also be an electrically erasable programmable read-only memory (EEPROM), a magnetic disk storage medium or other magnetic storage devices, or any other medium capable of being used to carry or store the desired program codes in the form of instructions or data structures and capable of being accessed by a computer.

As a possible implementation, the memory 2401 may exist independently of the processor 2402, and the memory 2401 may be connected to the processor 2402 via the bus 2404 and is used for storing instructions or program codes. The processor 2402, when calling and executing the instructions or program codes stored in the memory 2401, is capable of implementing the encoding method or the decoding method provided by the embodiments of the present disclosure.

As another possible implementation, the memory 2401 may also be integrated with the processor 2402.

The bus 2404 may be an extended industry standard architecture (EISA) bus or the like. Buses 2404 may be divided into address buses, data buses, control buses, and the like. For ease of representation, only one bold line is used for the representation in FIG. 24, but it does not mean that there is only one bus or one type of the bus.

In some embodiments, the above memory 2401 may store local buffers such as the first bit sequence, the second bit sequence, the first basic sub-matrix, the second basic sub-matrix, and the lifting size mentioned-above. In addition, the memory 2401 also stores program instructions, the processor 2402, when executing the program instructions, may encode a first bit sequence, to obtain a second bit sequence, and then send a part or all of the second bit sequence through the communication interface 2403.

In some embodiments, the processor 2402 may perform the methods described in S401-S403 above, and may also perform the methods described in S2101-S2102 above.

Some embodiments of the present disclosure provide a computer readable storage medium (e.g., a non-transitory computer readable storage medium) having stored computer program instructions therein, where the computer program instructions, when executed on a computer, cause the computer to perform the encoding method or the decoding method as described in any one of the above embodiments.

Exemplarily, the above-mentioned computer-readable storage medium may include, but be not limited to, a magnetic storage device (e.g., a hard disk, a floppy disk or a magnetic tape, etc.), an optical disk (e.g., a Compact Disk (CD) or a Digital Versatile Disk (DVD), etc.), a smart card and a flash memory device (e.g., an Erasable Programmable Read-Only Memory (EPROM), a card, a stick or a key driver, etc.). The various computer readable storage media described in the present disclosure may represent one or more devices for storing information and/or other machine readable storage media for storing information. The term "machine readable storage medium" may include, but is not limited to, a wireless channel and various other media capable of storing, containing, and/or carrying instructions and/or data.

The embodiments of the present disclosure provide a computer program product including instructions, and the computer program product, when executed on a computer, causes the computer to perform the beam handover method as described in any one of the above embodiments.

The foregoing descriptions are merely specific implementations of the present disclosure, but the protection scope of the present disclosure is not limited thereto. Any change or replacement within the technical scope disclosed in the present disclosure shall be included in the protection scope of the present disclosure. Therefore, the protection scope of the present disclosure shall be determined based on the protection scope of the claims.

**Claims**

1. An encoding method, **characterized in that** the method comprises:

   Acquiring to-be-encoded first bit sequence;
   encoding the first bit sequence based on a basic matrix of a spatially coupled low-density parity-check code (LDPC) and a lifting size, to obtain a second bit sequence, wherein the basic matrix comprises L basic sub-matrix groups that are identical and arranged diagonally, and the basic sub-matrix group comprises M first basic sub-matrices, wherein L and M are both positive integers; and
   sending all or a part of bits of the second bit sequence.

2. The method according to claim 1, wherein the first basic sub-matrix comprises a system column matrix and a parity column matrix, the system column matrix is formed by elements in first $k_b$ columns of the first basic sub-matrix, the parity column matrix is formed by elements in last $m_b$ columns of the first basic sub-matrix, and a sum of $k_b$ and $m_b$ is equal to a number of columns of the first basic sub-matrix, and $k_b$ and $m_b$ both are positive integers.

3. The method according to claim 2, wherein a parity column matrix of at least one first basic sub-matrix of the M first basic sub-matrices adopts any one of following structures:

   a Raptor-like structure;
   an identity matrix structure;
   a lower triangular structure;
   a quasi-lower triangular structure;
   a first preset structure, wherein column weights of first a columns of the parity column matrix adopting the first preset structure are greater than 0, and column weights of remaining columns are equal to 0 other than the first a columns, a is a positive integer; a column weight is a number of second elements in a column of elements, and a second element is used to indicate cyclic shift of the identity matrix; or
   a second preset structure, wherein all elements of the parity column matrix adopting the second preset structure are first elements, and a first element is used to indicate an all-zero square matrix.

4. The method according to claim 3, wherein a parity column matrix of a first first basic sub-matrix among the M first basic sub-matrices adopts a Raptor-like structure or an identity matrix structure.

5. The method according to claim 4, wherein
   in response to that a length of the first bit sequence is greater than a first threshold, the parity column matrix of the first first basic sub-matrix adopts the Raptor-like structure, and the first threshold is a positive integer; or, in response to that a length of the first bit sequence is less than or equal to a second threshold, the parity column matrix of the first first basic sub-matrix adopts an identity matrix structure, and the second threshold is a positive integer, and the first threshold is greater than or equal to the second threshold.

6. The method according to claim 4, wherein
   the first bit sequence comprises L first bit subsequences, in response to that a length of a first bit subsequence is greater than a third threshold, the parity column matrix of the first first basic sub-matrix adopts the Raptor-like structure, and the third threshold is a positive integer; or, in response to that a length of the first bit subsequence is less than or equal to a fourth threshold, the parity column matrix of the first first basic sub-matrix adopts the identity matrix structure, and the fourth threshold is a positive integer, the third threshold is greater than or equal to the fourth threshold, and L is a positive integer.

7. The method according to claim 3, wherein a structure of a parity column matrix of a first first basic sub-matrix among the M first basic sub-matrices is capable of being determined by at least one of following parameters: a length of the first bit sequence, a number of first bit subsequences comprised in the first bit sequence, or a length of the first bit subsequence.

8. The method according to claim 3, wherein

a parity column matrix of a first first basic sub-matrix among the M first basic sub-matrices adopts a Raptor-like structure, and a parity column matrix of a second first basic sub-matrix among the M first basic sub-matrices adopts an identity matrix structure; or
a parity column matrix of a first first basic sub-matrix among the M first basic sub-matrices adopts an identity matrix structure, and a parity column matrix of a second first basic sub-matrix among the M first basic sub-matrices adopts a Raptor-like structure.

9. The method according to claim 3, wherein a parity column matrix of a first first basic sub-matrix among the M first basic sub-matrices adopts a Raptor-like structure, and a parity column matrix of a second first basic sub-matrix among the M first basic sub-matrices adopts a first preset structure.

10. The method according to claim 9, wherein a value of a is less than or equal to a number of rows of a core matrix of the first first basic sub-matrix.

11. The method according to claim 10, wherein the number of rows of the core matrix of the first first basic sub-matrix is equal to 3, 4, 5, 6, or 8.

12. The method according to claim 3, wherein a parity column matrix of a first first basic sub-matrix among the M first basic sub-matrices adopts an identity matrix structure, and a parity column matrix of a second first basic sub-matrix among the M first basic sub-matrices adopts a first preset structure.

13. The method according to claim 12, wherein a is equal to 2, 3, 4, 5, 6, or 8.

14. The method according to claim 2, wherein there are b columns with the column weights equal to 0 and remaining columns with the column weights greater than 0 other than the b columns in a system column matrix of at least one first basic sub-matrix among the M first basic sub-matrices, a column weight is a number of second elements in a column of elements, and b is a positive integer.

15. The method according to claim 14, wherein the b columns with the column weights equal to 0 are first b columns of the system column matrix.

16. The method according to claim 1, wherein a number of rows of the M first basic sub-matrices is $m_b$, a number of columns of the M first basic sub-matrices is $n_b$, $n_b$ is greater than $m_b$, and $m_b$ and $n_b$ both are positive integers.

17. The method according to claim 1, wherein the first bit sequence comprises L first bit subsequences;
encoding the first bit sequence based on the basic matrix of the spatially coupled LDPC and the lifting size, to obtain the second bit sequence comprises:

encoding the L first bit subsequences based on the M first basic sub-matrices and the lifting size, to obtain L second bit subsequences; and
obtaining the second bit sequence based on the L second bit subsequences.

18. The method according to claim 1, wherein the basic matrix further comprises N second basic sub-matrices, wherein N is a positive integer.

19. The method according to claim 18, wherein the N second basic sub-matrices are arranged on a diagonal of a lower right sub-matrix of the basic matrix.

20. The method according to claim 18, wherein a number N of the second basic sub-matrix is less than a number M of the first basic sub-matrix.

21. The method according to claim 18, wherein the second basic sub-matrix adopts any one of following structures:

a Raptor-like structure;

an identity matrix structure;
a lower triangular structure;
a quasi-lower triangular structure.

22. The method according to claim 18, wherein a number of columns of the N second basic sub-matrices is $m_b$, and a number of rows of the N second basic sub-matrices is $m_b$, and $m_b$ is a positive integer.

23. The method according to claim 18, wherein the first bit sequence comprises L first bit subsequences;
encoding the first bit sequence based on the basic matrix of the spatially coupled low-density parity-check code (LDPC) and the lifting size, to obtain the second bit sequence comprises:

   encoding the L first bit subsequences based on the M first basic sub-matrices and the lifting size, to obtain L second bit subsequences;
   encoding last N second bit subsequences among the L second bit subsequences based on the N second basic sub-matrices, the lifting size, and last N first basic sub-matrices among the M first basic sub-matrices, to obtain N third bit subsequences;
   obtaining the second bit sequence based on the L second bit subsequences and the N third bit subsequences.

24. The method according to claim 1, wherein the lifting value is equal to a positive integer power of 2.

25. A decoding method, **characterized in that** the method comprises:

   receiving all or a part of bits of a second bit sequence; and
   decoding the all or part of bits of the second bit sequence based on a basic matrix of a spatially coupled low-density parity-check code (LDPC) and a lifting size, to obtain a first bit sequence, wherein the basic matrix comprises L basic sub-matrix groups that are identical and arranged diagonally, and the basic sub-matrix group comprises M first basic sub-matrices, wherein L and M both are positive integers.

26. The method according to claim 25, wherein the first basic sub-matrix comprises a system column matrix and a parity column matrix, the system column matrix is formed by elements in first $k_b$ columns of the first basic sub-matrix, the parity column matrix is formed by elements in last $m_b$ columns of the first basic sub-matrix, and a sum of $k_b$ and $m_b$ is equal to a number of columns of the first basic sub-matrix, and $k_b$ and $m_b$ both are positive integers;
a parity column matrix of at least one first basic sub-matrix of the M first basic sub-matrices adopts any one of following structures:

   a Raptor-like structure;
   an identity matrix structure;
   a lower triangular structure;
   a quasi-lower triangular structure;
   a first preset structure, wherein column weights of first a columns of the parity column matrix adopting the first preset structure are greater than 0, and column weights of remaining columns are equal to 0 other than the first a columns, a is a positive integer; the column weight is a number of second elements in a column of elements, and the second element is used to indicate cyclic shift of the identity matrix; or
   a second preset structure, wherein all elements of the parity column matrix adopting the second preset structure are first elements, and the first element is used to indicate an all-zero square matrix.

27. The method according to claim 25, wherein a parity column matrix of a first first basic sub-matrix among the M first basic sub-matrices adopts a Raptor-like structure or an identity matrix structure.

28. The method according to claim 25, wherein the basic matrix further comprises N second basic sub-matrices, the N second basic sub-matrices are arranged on a diagonal of a lower right sub-matrix of the basic matrix, wherein N is a positive integer.

29. A communication apparatus, **characterized by** comprising a memory, a processor, and computer program instructions stored on the memory and runnable on the processor, wherein the processor, when executing the computer program instructions, implements the method according to any one of claims 1 to 28.

30. A computer readable storage medium, **characterized in that** the computer readable storage medium comprises computer program instructions; wherein the computer program instructions, when executed on a computer, cause the computer to perform the method according to any one of claims 1 to 28.

FIG. 1

FIG. 2

FIG. 3

FIG. 4

Acquire a to-be-encoded first bit sequence — S401

Encode L first bit subsequences based on M first basic sub-matrices and a lifting size, to obtain L second bit subsequences — S4021a

Obtain a second bit sequence based on the L second bit subsequences — S4022a

Send all or a part of bits of the second bit sequence — S403

FIG. 5

Acquire a to-be-encoded first bit sequence — S401

Encode L first bit subsequences based on M first basic sub-matrices and a lifting size, to obtain L second bit subsequences — S4021b

Encode last N second bit subsequences among the L second bit subsequences based on the N second basic sub-matrices, the lifting size, and last N first basic sub-matrices among the M first basic sub-matrices, to obtain N third bit subsequences — S4022b

Obtain a second bit sequence based on the L second bit subsequences and the N third bit subsequences — S4023b

Send all or a part of bits of the second bit sequence — S403

FIG. 6

FIG. 7

FIG. 8

FIG. 9

FIG. 10

FIG. 11

FIG. 12

(a)

(b)

FIG. 13

|   | 0 | 1 | 2 | 3 | 4 | 5 | 6 | 7 |
|---|---|---|---|---|---|---|---|---|
| 0 | 0 | -1 | -1 | -1 | -1 | -1 | -1 | -1 |
| 1 | -1 | 0 | -1 | -1 | -1 | -1 | -1 | -1 |
| 2 | -1 | -1 | 0 | -1 | -1 | -1 | -1 | -1 |
| 3 | -1 | -1 | -1 | 0 | -1 | -1 | -1 | -1 |
| 4 | -1 | -1 | -1 | -1 | 0 | -1 | -1 | -1 |
| 5 | -1 | -1 | -1 | -1 | -1 | 0 | -1 | -1 |
| 6 | -1 | -1 | -1 | -1 | -1 | -1 | 0 | -1 |
| 7 | -1 | -1 | -1 | -1 | -1 | -1 | -1 | 0 |

FIG. 14

(a)

1501    1502

(b)

1503    1504

FIG. 15

FIG. 16

FIG. 17

(a)

1801          1802

(a)

1803          1804

FIG. 18

1901          1902

(a)

1903          1904

(b)

FIG. 19

```
     0   1   2   3   4   5   6   7   8   9
 0   0  -1  -1  -1  -1  -1  -1  -1  -1  -1
 1   0   0  -1  -1  -1  -1  -1  -1  -1  -1
-1  -1   0   0  -1  -1  -1  -1  -1  -1  -1
 0  -1  -1   0  -1  -1  -1  -1  -1  -1  -1
-1  -1   5  -1   0  -1  -1  -1  -1  -1  -1
11  -1  -1  -1  -1   0  -1  -1  -1  -1  -1
-1  11  -1  -1  -1  -1   0  -1  -1  -1  -1
-1  -1  -1   3  -1  -1  -1   0  -1  -1  -1
-1  -1   1  -1  -1  -1  -1  -1   0  -1  -1
-1   7  -1  -1  -1  -1  -1  -1  -1   0  -1

                ( a )
```

```
     0   1   2   3   4   5   6   7   8   9
 0  -1  -1  -1  -1  -1  -1  -1  -1  -1  -1
-1   0  -1  -1  -1  -1  -1  -1  -1  -1  -1
-1  -1   0  -1  -1  -1  -1  -1  -1  -1  -1
-1  -1  -1   0  -1  -1  -1  -1  -1  -1  -1
-1  -1  -1  -1   0  -1  -1  -1  -1  -1  -1
-1  -1  -1  -1  -1   0  -1  -1  -1  -1  -1
-1  -1  -1  -1  -1  -1   0  -1  -1  -1  -1
-1  -1  -1  -1  -1  -1  -1   0  -1  -1  -1
-1  -1   1  -1  -1  -1  -1  -1   0  -1  -1
-1  -1  -1  -1  -1  -1  -1  -1  -1   0  -1

                ( b )
```

```
     0   1   2   3   4   5   6   7   8   9
 0  -1  -1  -1  -1  -1  -1  -1  -1  -1
-1   0  -1  -1  -1  -1  -1  -1  -1  -1
 1  -1   0  -1  -1  -1  -1  -1  -1  -1
-1  -1   1   0  -1  -1  -1  -1  -1  -1
-1   5  -1  -1   0  -1  -1  -1  -1  -1
-1  -1  11  -1  -1   0  -1  -1  -1  -1
-1  -1  -1  -1  13  -1   0  -1  -1  -1
-1   7  -1   9  -1  -1  -1   0  -1  -1
-1  -1   1  14  -1  -1  15  -1   0  -1
 9  -1  -1  -1  -1  11  -1  -1  -1   0

                ( c )
```

```
     0   1   2   3   4   5   6   7   8   9
 0   0  -1  -1  -1  -1  -1  -1  -1  -1
 1   0   0  -1  -1  -1  -1  -1  -1  -1
-1  -1   0   0  -1  -1  -1  -1  -1  -1
 0  -1  -1   0  -1  -1  -1  -1  -1  -1
-1  -1   5  -1   0  -1  -1  -1  -1  -1
11  -1  -1   4  -1   0  -1  -1  -1  -1
-1  11  -1  -1  -1  -1   0  -1  -1  -1
-1  -1  -1   3  14  -1  -1   0  -1  -1
-1  -1   1  -1  -1  -1  10  -1   0  -1
-1   7  -1  -1  -1  15  -1   1  -1   0

                ( d )
```

```
     0   1   2   3   4   5   6   7   8   9
 3   1  -1  -1  -1  -1  -1  -1  -1  -1
 1   0   0  -1  -1  -1  -1  -1  -1  -1
-1  -1  13  12  -1  -1  -1  -1  -1  -1
 0  -1  -1   0  -1  -1  -1  -1  -1  -1
-1  -1   5  -1  -1  -1  -1  -1  -1  -1
11  -1  -1   4  -1  -1  -1  -1  -1  -1
-1  11  -1  -1  -1  -1  -1  -1  -1  -1
-1  -1  -1   3  -1  -1  -1  -1  -1  -1
-1  -1   2  -1  -1  -1  -1  -1  -1  -1
-1   7  -1  -1  -1  -1  -1  -1  -1  -1

                ( e )
```

```
     0   1   2   3   4   5   6   7   8   9
-1  -1  -1  -1  -1  -1  -1  -1  -1  -1
-1  -1  -1  -1  -1  -1  -1  -1  -1  -1
-1  -1  -1  -1  -1  -1  -1  -1  -1  -1
-1  -1  -1  -1  -1  -1  -1  -1  -1  -1
-1  -1  -1  -1  -1  -1  -1  -1  -1  -1
 1   1   1   1   1   1   1   1   1   1
-1  -1  -1  -1  -1  -1  -1  -1  -1  -1
-1  -1  -1  -1  -1  -1  -1  -1  -1  -1
-1  -1  -1  -1  -1  -1  -1  -1  -1  -1

                ( f )
```

FIG. 20

Receive all or a part of bits of a second bit sequence — S2101

Decode the all or part of the bits of the second bit sequence based on a basic matrix of a spatially coupled LDPC and a lifting size, to obtain a first bit sequence — S2102

FIG. 21

Encoding
apparatus

Acquiring
module 2201

Encoding
apparatus 2202

Sending module
2203

FIG. 22

Decoding
apparatus

Receiving
module 2301

Decoding
module 2302

FIG. 23

240

2402

2403

2404

Processor

Communicat-
ion interface

Bus

Memory

2401

FIG. 24

FIG. 25

## INTERNATIONAL SEARCH REPORT

| International application No. |
| --- |
| **PCT/CN2024/086664** |

### A. CLASSIFICATION OF SUBJECT MATTER

H03M 13/11(2006.01)i

According to International Patent Classification (IPC) or to both national classification and IPC

### B. FIELDS SEARCHED

Minimum documentation searched (classification system followed by classification symbols)

IPC: H03M

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: LDPC, 低密度奇偶校验码, 基础矩阵, 提升值, 编码, 解码, 译码, low density parity check, basis matrix, enhancement value, code, encode, decode

### C. DOCUMENTS CONSIDERED TO BE RELEVANT

| Category* | Citation of document, with indication, where appropriate, of the relevant passages | Relevant to claim No. |
| --- | --- | --- |
| A | CN 109120374 A (ZTE CORP.) 01 January 2019 (2019-01-01)<br>description, paragraph [0024] | 1-30 |
| A | CN 107370490 A (ZTE CORP.) 21 November 2017 (2017-11-21)<br>entire document | 1-30 |
| A | CN 108270448 A (ZTE CORP.) 10 July 2018 (2018-07-10)<br>entire document | 1-30 |
| A | CN 109327225 A (HUAWEI TECHNOLOGIES CO., LTD.) 12 February 2019 (2019-02-12)<br>entire document | 1-30 |

☐ Further documents are listed in the continuation of Box C.   ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **20 June 2024** | **25 June 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

| International application No. |
| --- |
| **PCT/CN2024/086664** |

| Patent document cited in search report | | | Publication date (day/month/year) | Patent family member(s) | | | Publication date (day/month/year) |
| --- | --- | --- | --- | --- | --- | --- | --- |
| CN | 109120374 | A | 01 January 2019 | US | 2022069843 | A1 | 03 March 2022 |
| | | | | US | 11626888 | B2 | 11 April 2023 |
| | | | | KR | 20200035023 | A | 01 April 2020 |
| | | | | KR | 102303379 | B1 | 24 September 2021 |
| | | | | EP | 3648379 | A1 | 06 May 2020 |
| | | | | EP | 3648379 | A4 | 08 July 2020 |
| | | | | US | 2020145026 | A1 | 07 May 2020 |
| | | | | US | 11159178 | B2 | 26 October 2021 |
| | | | | AU | 2018295221 | A1 | 06 February 2020 |
| | | | | AU | 2018295221 | B2 | 24 June 2021 |
| | | | | JP | 2020526117 | A | 27 August 2020 |
| | | | | JP | 6990259 | B2 | 12 January 2022 |
| | | | | CA | 3068497 | A1 | 03 January 2019 |
| | | | | CA | 3068497 | C | 30 August 2022 |
| | | | | SG | 11201913212 | QA | 30 January 2020 |
| | | | | RU | 2743857 | C1 | 01 March 2021 |
| | | | | WO | 2019001263 | A1 | 03 January 2019 |
| CN | 107370490 | A | 21 November 2017 | KR | 20210032007 | A | 23 March 2021 |
| | | | | KR | 102347823 | B1 | 05 January 2022 |
| | | | | JP | 2022058949 | A | 12 April 2022 |
| | | | | JP | 7372369 | B2 | 31 October 2023 |
| | | | | KR | 20190008335 | A | 23 January 2019 |
| | | | | KR | 102229233 | B1 | 22 March 2021 |
| | | | | US | 2021091790 | A1 | 25 March 2021 |
| | | | | US | 11323134 | B2 | 03 May 2022 |
| | | | | JP | 2019517209 | A | 20 June 2019 |
| | | | | JP | 7025349 | B2 | 24 February 2022 |
| | | | | EP | 4231532 | A2 | 23 August 2023 |
| | | | | EP | 4231532 | A3 | 30 August 2023 |
| | | | | US | 2020244287 | A1 | 30 July 2020 |
| | | | | US | 10892778 | B2 | 12 January 2021 |
| | | | | EP | 3457575 | A1 | 20 March 2019 |
| | | | | EP | 3457575 | A4 | 04 December 2019 |
| | | | | EP | 3457575 | B1 | 23 August 2023 |
| CN | 108270448 | A | 10 July 2018 | WO | 2018126788 | A1 | 12 July 2018 |
| CN | 109327225 | A | 12 February 2019 | MY | 196344 | A | 24 March 2023 |
| | | | | BR | 112019027876 | A2 | 07 July 2020 |
| | | | | US | 2022231705 | A1 | 21 July 2022 |
| | | | | US | 11671116 | B2 | 06 June 2023 |
| | | | | JP | 2022179504 | A | 02 December 2022 |
| | | | | JP | 7471360 | B2 | 19 April 2024 |
| | | | | PL | 3567731 | T3 | 28 February 2022 |
| | | | | KR | 20200013794 | A | 07 February 2020 |
| | | | | KR | 102276721 | B1 | 12 July 2021 |
| | | | | US | 2020052720 | A1 | 13 February 2020 |
| | | | | US | 10771092 | B2 | 08 September 2020 |
| | | | | EP | 3567731 | A1 | 13 November 2019 |
| | | | | EP | 3567731 | A4 | 01 July 2020 |
| | | | | EP | 3567731 | B1 | 12 January 2022 |
| | | | | ES | 2907089 | T3 | 21 April 2022 |

Form PCT/ISA/210 (patent family annex) (July 2022)

| INTERNATIONAL SEARCH REPORT | | | | International application No. |
| --- | --- | --- | --- | --- |
| Information on patent family members | | | | **PCT/CN2024/086664** |

| Patent document cited in search report | Publication date (day/month/year) | Patent family member(s) | | Publication date (day/month/year) |
| --- | --- | --- | --- | --- |
| | | JP | 2020526111 A | 27 August 2020 |
| | | JP | 7143343 B2 | 28 September 2022 |
| | | AU | 2018294981 A1 | 30 January 2020 |
| | | AU | 2018294981 B2 | 22 October 2020 |
| | | BR | 112019027688 A8 | 29 September 2020 |
| | | RU | 2020102671 A | 27 July 2021 |
| | | RU | 2020102671 A3 | 07 September 2021 |
| | | RU | 2758968 C2 | 03 November 2021 |
| | | US | 2021058095 A1 | 25 February 2021 |
| | | US | 11277153 B2 | 15 March 2022 |
| | | EP | 4376337 A2 | 29 May 2024 |
| | | CA | 3068553 A1 | 03 January 2019 |
| | | EP | 4064573 A1 | 28 September 2022 |
| | | EP | 4064573 B1 | 27 December 2023 |
| | | US | 2023361787 A1 | 09 November 2023 |
| | | ES | 2970217 T3 | 27 May 2024 |

Form PCT/ISA/210 (patent family annex) (July 2022)

**EP 4 723 487 A1**

**Patent documents cited in the description**

- CN 202310709637